# EUROPEAN PATENT APPLICATION

(11) **EP 4 362 635 A2**
(43) Date of publication of application: **01.05.2024**
(21) Application number: 23204483.4
(22) Date of filing: 18.10.2023
(51) Int. Cl.: H10K 59/122, H10K 59/86, H10K 59/121, H10K 59/131

(54) **LIGHT EMITTING DISPLAY DEVICE**

(30) Priority: 26.10.2022 KR 20220139610
(71) Applicant: Samsung Display Co., Ltd., Yongin-si, Gyeonggi-do 17113 (KR)
(72) Inventor: CHOI, Chung Sock, Yongin-si (KR); KIM, Sun Ho, Yongin-si (KR); KO, Yoo Min, Yongin-si (KR); KIM, Hye Won, Yongin-si (KR); PARK, Ju Chan, Yongin-si (KR); LEE, Pil Suk, Yongin-si (KR); HONG, Sung Jin, Yongin-si (KR)
(74) Representative: Marks & Clerk LLP

(57) **Abstract**

A light emitting display device includes a first display area; and a second display area disposed on an external side of the first display area, wherein the second display area includes a pixel driver, a main light emitting diode electrically connected to the pixel driver, and an additional light emitting diode electrically connected to the main light emitting diode, the additional light emitting diode overlaps a peripheral driver that generates signals provided to the pixel driver, the main light emitting diode and the additional light emitting diode each include a first electrode, an emission layer, and a second electrode, and the second electrode of the main light emitting diode is electrically connected to the first electrode of the additional light emitting diode.

## Description

### BACKGROUND

### 1. Technical Field

The disclosure relates to a light emitting display device, and specifically relates to a light emitting display device including a light emitting diode disposed in a non-display area and displaying images.

### 2. Description of the Related Art

A display device may include a display area for displaying images and a non-display area for displaying no images. Multiple pixels may be disposed in a row direction and a column direction in the display area. Various elements such as transistors or capacitors and various wires for supplying signals to them may be disposed in the respective pixels. Various peripheral drivers (a scan signal generator, a data driver, or a timing controller) for transmitting electrical signals, and wires, may be disposed in the non-display area to drive pixels.

Regarding some of the display devices, a camera or a sensor is positioned in the display area so there is a portion for displaying no images in a region of the display area. The display device may reduce the non-display area as a merit, but may have a drawback that a non-display area for displaying no images is positioned in the display area.

The above information disclosed in this Background section is only for enhancement of understanding of the background of the disclosure, and therefore it may contain information that does not form the prior art that is already known in this country to a person of ordinary skill in the art.

### SUMMARY

The disclosure has been made in an effort to provide a light emitting display device for increasing a display area or reducing an area occupied by a non-display area.

The technical objectives to be achieved by the disclosure are not limited to those described herein, and other technical objectives that are not mentioned herein would be clearly understood by a person skilled in the art from the description of the disclosure.

An embodiment of the disclosure provides a light emitting display device including: a first display area; and a second display area disposed on an external side of the first display area, wherein the second display area includes a pixel driver, a main light emitting diode electrically connected to the pixel driver, and an additional light emitting diode electrically connected to the main light emitting diode, the additional light emitting diode overlaps a peripheral driver that generates signals provided to the pixel driver, the main light emitting diode and the additional light emitting diode each include a first electrode, an emission layer, and a second electrode, and the second electrode of the main light emitting diode is electrically connected to the first electrode of the additional light emitting diode.

The second electrode of the main light emitting diode may be electrically disconnected from the second electrode of the additional light emitting diode by a separator.

The light emitting display device may further include a pixel defining layer including an opening overlapping the first electrode of the main light emitting diode and the first electrode of the additional light emitting diode, wherein the separator may be disposed on the pixel defining layer, and the separator may have a protruding structure including an inversely tapered side wall.

The light emitting display device may further include an additional conductive portion overlapping part of the separator, disposed below the separator, and extending along the separator, wherein the additional conductive portion may be electrically connected to an end of the second electrode separated by the separator.

The light emitting display device may further include a pixel defining layer including an opening overlapping the first electrode of the main light emitting diode and the first electrode of the additional light emitting diode, wherein the separator may be provided to be a concave groove in the pixel defining layer.

The light emitting display device may further include an auxiliary anode connecting line that electrically connects the second electrode of the main light emitting diode and the first electrode of the additional light emitting diode, wherein the auxiliary anode connecting line may have a triple-layered structure, and the second electrode of the main light emitting diode and the auxiliary anode connecting line have portions side-contacting each other.

The light emitting display device may further include an auxiliary connecting member disposed between the portions of the second electrode of the main light emitting diode and the auxiliary anode connecting line, wherein the auxiliary connecting member and the first electrode of the main light emitting diode include a same material.

The light emitting display device may further include an additional separator disposed between the first display area and the second display area, wherein the first display area may include a pixel driver, and a first light emitting diode electrically connected to the pixel driver, the first light emitting diode may include a first electrode, an emission layer, and a second electrode, and a voltage applied to the second electrode of the first light emitting diode and a voltage applied to the second electrode of the additional light emitting diode may have different voltage values.

The second display area may further include a second-4 light emitting diode and a second-5 light emitting diode electrically connected in series, and the second-4 light emitting diode and the second-5 light emitting diode may be electrically connected in parallel to the main light emitting diode and the additional light emitting diode.

The main light emitting diode and the additional light emitting diode may emit one of red, green, and blue, the main light emitting diode may include main light emitting diodes, the additional light emitting diode may include additional light emitting diodes, and a number of the additional light emitting diodes electrically connected to the main light emitting diode emitting one of red, green, and blue is different from a number of the additional light emitting diodes electrically connected to the main light emitting diode emitting another of red, green, and blue.

The second display area may be disposed on a portion that corresponds to a corner of the first display area, the main light emitting diode includes main light emitting diodes, the additional light emitting diode includes additional light emitting diodes, and at least one of the main light emitting diodes may include a unit second light emitting diode in which a number of the additional light emitting diodes electrically connected to one of the main light emitting diodes may be different from a number of the additional light emitting diodes electrically connected to another one of the main light emitting diodes.

Another embodiment of the disclosure provides a light emitting display device including: a first display area; and a second display area surrounded by the first display area and including a light transmitting area, wherein the second display area includes a pixel driver, and a main light emitting diode and an additional light emitting diode electrically connected to the pixel driver, the main light emitting diode and the additional light emitting diode each include a first electrode, an emission layer, and a second electrode, and the second electrode of the main light emitting diode is electrically connected to the first electrode of the additional light emitting diode.

The second electrode of the main light emitting diode may be electrically disconnected from the second electrode of the additional light emitting diode by a separator.

The light emitting display device may further include a pixel defining layer including an opening overlapping the first electrode of the main light emitting diode and the first electrode of the additional light emitting diode, wherein the separator may be disposed on the pixel defining layer, and the separator may have a protruding structure including an inversely tapered side wall.

The light emitting display device may further include an additional conductive portion overlapping part of the separator, disposed below the separator, and extending along the separator, wherein the additional conductive portion may be electrically connected to an end of a cathode separated by the separator.

The light emitting display device may further include a pixel defining layer including an opening overlapping the first electrode of the main light emitting diode and the first electrode of the additional light emitting diode, wherein the separator may have a concave groove in the pixel defining layer.

The light emitting display device may further include an auxiliary anode connecting line that electrically connects a cathode of the main light emitting diode and an anode of the additional light emitting diode, wherein the auxiliary anode connecting line may include a transparent conductive material.

The light emitting display device may further include an additional separator disposed between the first display area and the second display area, wherein the first display area may include a pixel driver and a first light emitting diode electrically connected to the pixel driver, the first light emitting diode may include a first electrode, an emission layer, and a second electrode, and a voltage applied to the second electrode of the first light emitting diode and a voltage applied to the second electrode of the additional light emitting diode may have different voltage values.

The second display area may further include a lower shielding layer partitioning the light transmitting area, the lower shielding layer including a metal, the main light emitting diode and the additional light emitting diode may include a main unit light emitting diode and an additional unit light emitting diode, respectively, the main unit light emitting diode may include main light emitting diodes emitting red, green and blue, the additional unit light emitting diode may include additional light emitting diodes emitting at least two of red, green and blue, and the main unit light emitting diode and the additional unit light emitting diode may be disposed on the lower shielding layer.

The additional unit light emitting diode may include a first additional unit light emitting diode including the additional light emitting diode emitting green and the additional light emitting diode emitting blue, and a second additional unit light emitting diode including the additional light emitting diode emitting green and the additional light emitting diode emitting red.

According to the embodiments, the light emitting diode is positioned on the upper portion of the peripheral driver or the upper portion of the region in which the camera is positioned on the rear side, thereby expanding the display area or reducing the region occupied by the non-display area.

According to an embodiment, there is provided a light emitting display device comprising: a first display area; and a second display area disposed adjacent the first display area, wherein the second display area includes: a pixel driver; a main light emitting diode electrically connected to the pixel driver; and an additional light emitting diode electrically connected in series or parallel with the main light emitting element, the main light emitting diode and the additional light emitting diode each include a first electrode, an emission layer, and a second electrode, and the second electrode of the main light emitting diode is electrically connected to the first electrode of the additional light emitting diode.

At least some of the above features that accord with the invention and other features according to the invention are set out in the claims.

### BRIEF DESCRIPTION OF THE DRAWINGS

FIG. 1 illustrates a schematic plan view of a light emitting display device according to an embodiment.
FIG. 2 illustrates a schematic cross-sectional view of a portion shown in FIG. 1.
FIG. 3 and FIG. 4 illustrate schematic diagrams of equivalent circuits of pixels disposed on different regions included in a light emitting display device according to an embodiment.
FIG. 5 illustrates a schematic plan view of a connection between a pixel driver and a light emitting diode according to an embodiment.
FIG. 6 illustrates a schematic cross-sectional view of a connection of a light emitting diode according to an embodiment of FIG. 5.
FIG. 7 and FIG. 8 illustrate schematic diagram of equivalent circuits of pixels disposed on different regions included in a light emitting display device according to another embodiment.
FIG. 9 and FIG. 10 illustrate schematic plan views of a connection between a pixel driver and a light emitting diode according to an embodiment of FIG. 7 and FIG. 8.
FIG. 11 illustrates a schematic plan view of a light emitting display device according to another embodiment.
FIG. 12 illustrates a schematic plan view of a light emitting display device according to another embodiment.
FIG. 13 illustrates a schematic cross-sectional view of a portion shown in FIG. 12.
FIG. 14 schematic a schematic plan view of a connection between a pixel driver and a light emitting diode according to an embodiment of FIG. 12.
FIG. 15 illustrates a schematic cross-sectional view of a connection of a light emitting diode according to an embodiment of FIG. 14.
FIG. 16 illustrates a schematic plan view of a connection between a pixel driver and a light emitting diode according to an embodiment of FIG. 14.
FIG. 17 and FIG. 18 illustrate a schematic diagram of an equivalent circuit of a pixel and a cross-sectional view of a light emitting display device according to another embodiment, respectively.
FIG. 19 and FIG. 20 illustrate a schematic diagram of an equivalent circuit of a pixel and a cross-sectional view of a light emitting display device according to another embodiment, respectively.
FIG. 21 and FIG. 22 illustrate schematic cross-sectional views of a light emitting display device according to another embodiment.
FIG. 23 and FIG. 24 illustrate a schematic cross-sectional view and a schematic plan view of a light emitting display device according to another embodiment, respectively.
FIG. 25 to FIG. 28 illustrate schematic plan views of a light emitting display device according to another embodiment.

### DETAILED DESCRIPTION OF THE EMBODIMENTS

The disclosure will be described hereinafter with reference to the accompanying drawings, in which embodiments of the disclosure are shown. As those skilled in the art would realize, the described embodiments may be modified in various different ways, all without departing from the scope of the claims.

The drawings and description are to be regarded as illustrative in nature and not restrictive. Like reference numerals and/or like reference characters designate like elements throughout the specification.

The size and thickness of each configuration shown in the drawings may be arbitrarily shown for better understanding and ease of description, but the disclosure is not limited thereto. In the drawings, the thickness of layers, films, panels, regions, etc., may be enlarged for clarity. For better understanding and ease of description, the thicknesses of some layers and areas may be exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" means positioned on or below the object portion, and does not necessarily mean positioned "on" or "above" the upper side of the object portion based on a gravitational direction.

Unless explicitly described to the contrary, the word "comprise", "include," "have, "and their variations such as "comprises" or "comprising", will be understood to imply the inclusion of stated elements but not the exclusion of any other elements.

The phrase "on a plane" or "in a plan view" means viewing the object portion from the top, and the phrase "on a cross-section" or "in a cross-sectional view" means viewing a cross-section of which the object portion is vertically cut from the side.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements.

When the parts such as wires, layers, films, regions, plates, or constituent elements are described to extend in the "first direction or the second direction", this not only signifies a straight-line shape running straight in a corresponding direction, but also includes a structure generally extending in the first direction or the second direction, a structure bent on a predetermined portion, a zigzag-shaped structure, or a structure including a curved structure and extending.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

A description that a component is "configured to" perform a specified operation may be defined as a case where the component is constructed and arranged with structural features that can cause the component to perform the specified operation.

The term "and/or" includes all combinations of one or more of which associated configurations may define. For example, "A and/or B" may be understood to mean "A, B, or A and B."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

Electronic devices (e.g., mobile phones, TVs, monitors, laptop computers, etc.,) including the display device and the display panel described in the specification or the electronic devices including the display device and the display panel manufactured by a manufacturing method described in the specification are not excluded from the claimed range of the specification.

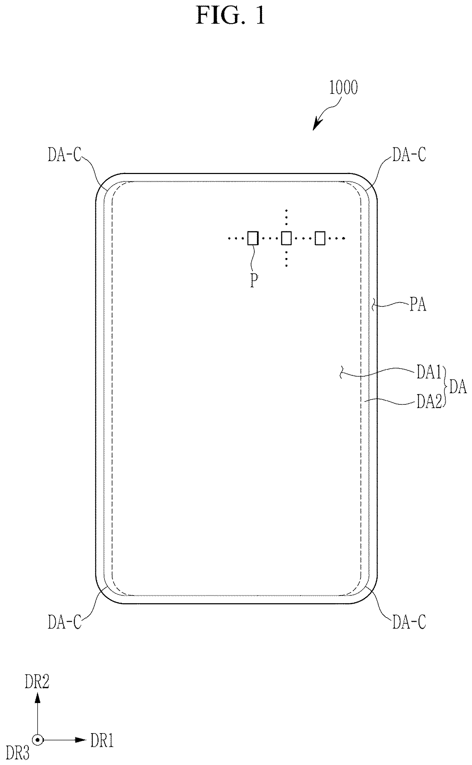

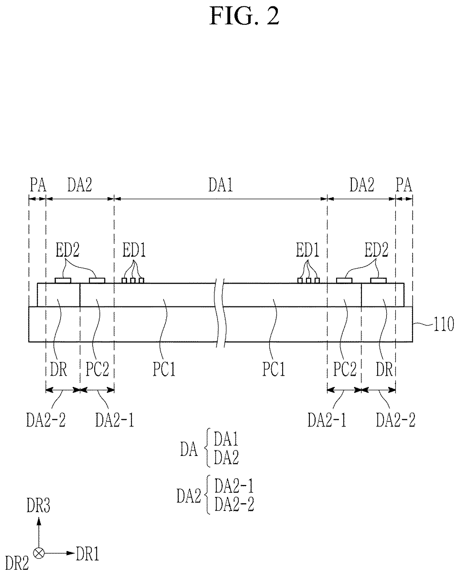

A schematic structure of a light emitting display device according to an embodiment will now be described with reference to FIGS. 1 and 2.

FIG. 1 illustrates a schematic plan view of a light emitting display device according to an embodiment, and FIG. 2 illustrates a schematic cross-sectional view of a portion shown in FIG. 1.

Referring to FIG. 1, the light emitting display device 1000 may include a display area DA in which pixels P are disposed and which displays images and a non-display area PA provided near (or adjacent to) the display area DA. The non-display area PA may display no images.

The display area DA may, for example, have a square shape, and in some embodiments, respective corners DA-C of the display area DA may have a round shape as shown in FIG. 1. The non-display area PA may be adjacent to or surround the display area DA. However, without being limited thereto, the display area DA and the non-display area PA may be designed to have various shapes.

The display area DA may include a first display area DA1, and a second display area DA2 disposed between the first display area DA1 and the non-display area PA.

The first display area DA1 may be disposed in a center of the display area DA, and the second display area DA2 may be disposed on sides of the first display area DA1, for example, a right side and a left side. However, the embodiments are not limited thereto. For example, the positions of the first display area DA1 and the second display area DA2 may be modifiable in many ways. For example, the first display area DA1 may have a substantially quadrangular shape, and the second display area DA2 may be disposed to surround four sides and corners of the first display area DA1.

The non-display area PA may surround the display area DA. The non-display area PA may display no images and it may be disposed on an external portion of the light emitting display device 1000. At least part of the light emitting display device 1000 may be a flexible display device including a bending portion. For example, the light emitting display device 1000 may have a planar center and a bent edge. In this instance, at least part of the second display area DA2 may be disposed on or in the bending portion so at least part of the second display area DA2 may have a bent shape.

Regarding the light emitting display device 1000, a side for displaying images may be parallel to a side defined by a first direction DR1 and a second direction DR2. A normal direction of the side for displaying images, e.g., a thickness direction of the light emitting display device 1000, may be indicated by a third direction DR3. Front sides (or upper sides) and rear sides (or lower sides) of the respective members may be distinguished by the third direction DR3. However, the directions indicated by the first to third directions DR1, DR2, and DR3 are a relative concept and they may be changed to other directions.

The light emitting display device 1000 may further include a touch unit and/or a cover window at a top side thereof.

The light emitting display device 1000 may be a flat rigid display device, and without being limited thereto, it may be a flexible display device. The light emitting display device 1000 may include an organic or inorganic emission layer, and may also include a color converting layer and/or a color filter including quantum dots.

FIG. 2 illustrates a schematic cross-sectional structure of the first display area DA1, the second display area DA2, and the non-display area PA of the light emitting display device 1000.

The light emitting display device 1000 may include a substrate 110, pixel drivers PC1 and PC2 disposed on the substrate 110, and light emitting diodes ED1 and ED2 for receiving (or configured to receive) light emitting currents from the pixel drivers PC1 and PC2.

The light emitting diodes ED1 and ED2 may emit light (e.g., a predetermined or selectable light) to display luminance or may display colors in addition to the luminance. For example, the displayable colors may include at least one of red, green, blue, and white light. The light emitting display device 1000 may display images through the light emitted by the light emitting diodes ED1 and ED2.

The light emitting diodes ED1 and ED2 may include a first light emitting diode ED1 and a second light emitting diode ED2. The light emitting diodes ED1 and ED2 may be disposed in the display area DA.

The first light emitting diode ED1 may be disposed in the first display area DA1, and the second light emitting diode ED2 may be disposed in the second display area DA2. Referring to FIG. 2, part of the second light emitting diode ED2 may be disposed on an upper portion of a peripheral driver DR. The light emitting display device 1000 may include multiple first light emitting diodes ED1 and multiple second light emitting diodes ED2. The first light emitting diodes ED1 may be disposed in the first direction DR1 and the second direction DR2 in the first display area DA1, and the second light emitting diodes ED2 may be disposed in the first direction DR1 and the second direction DR2 in the second display area DA2. Sizes of the first light emitting diodes ED1 may be substantially equal to or different from sizes of the second light emitting diodes ED2. For example, the second light emitting diodes ED2 may be larger than the first light emitting diodes ED1. The number of the first light emitting diodes ED1 per area may be substantially equal to or different from the number of the second light emitting diodes ED2 per area. For example, the number of the second light emitting diodes ED2 per area may be less than the number of the first light emitting diodes ED1 per area. A resolution of the first display area DA1 may be substantially equal to or different from a resolution of the second display area DA2. For example, the resolution of the first display area DA1 may be greater than the resolution of the second display area DA2. The disposition and the size of the first light emitting diode ED1 and the second light emitting diode ED2, and the resolution of the first display area DA1 and the second display area DA2 are not limited thereto and may be modifiable in many ways.

Regarding the light emitting display device 1000 disposed on the substrate 110, the pixel drivers PC1 and PC2 may include a first pixel driver PC1 and a second pixel driver PC2. FIG. 2 illustrates that first pixel drivers PC1 may be disposed in the first direction DR1 and the second direction DR2, and second pixel drivers PC2 may be disposed in the first direction DR1 and the second direction DR2. The disposition of the pixel drivers PC1 and PC2 is not specifically limited, and may be modifiable in many ways. The first pixel driver PC1 may be disposed in the first display area DA1, and the second pixel driver PC2 may be disposed in the second display area DA2. The respective pixel drivers PC1 and PC2 may be electrically connected to at least one of the light emitting diodes ED1 and ED2. A first pixel driver PC1 may be electrically connected to a first light emitting diode ED1, and a second pixel driver PC2 may be electrically connected to at least two second light emitting diodes ED2. The size of the first pixel driver PC1 may be equal to or different from the size of the second pixel driver PC2. For example, the second pixel driver PC2 may be larger than the first pixel driver PC1.

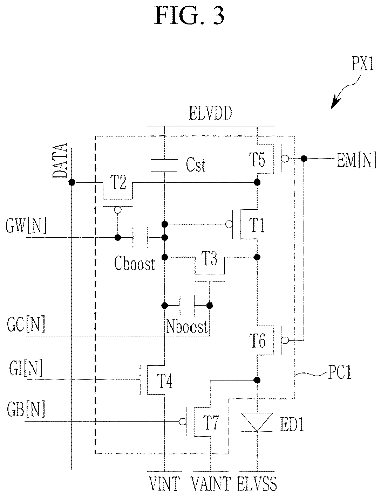

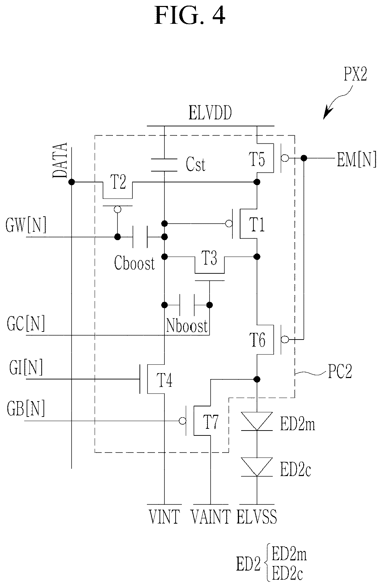

Referring to FIG. 2, the light emitting display device 1000 may further include a peripheral driver DR disposed on the substrate 110. The peripheral driver DR may generate signals for operating the first pixel driver PC1 and the second pixel driver PC2, may transmit the signals, and may be electrically connected to the first pixel driver PC1 and the second pixel driver PC2. The peripheral driver DR may, for example, include signal generators such as a scan signal generator or a light-emitting control signal generator and signal transmitting wires electrically connected to the signal generators. The peripheral driver DR may include a generator for generating a first scan signal GW[N], a second scan signal GC[N], an initialization signal GI[N], a bypass control signal GB[N], and a light-emitting control signal EM[N] described with reference to FIGS. 3 and 4. The peripheral driver DR may further include a data driver or wires (a driving voltage supplying line and a common voltage supplying line) for transmitting voltages. At least part of the peripheral driver DR may be disposed in the second display area DA2, and in some embodiments, part of the peripheral driver DR may be disposed in the non-display area PA.

The first display area DA1 may emit light by the first light emitting diode ED1. A first pixel driver PC1 and a first light emitting diode ED1 for receiving a light emitting current from the first pixel driver PC1 may be formed in the first display area DA1. At least part of the first light emitting diode ED1 may overlap (e.g., in a view or direction) the first pixel driver PC1 electrically connected to the first light emitting diode ED1. A combination of a first pixel driver PC1 formed in the first display area DA1 and a first light emitting diode ED1 for receiving a light emitting current therefrom will be referred to as a first pixel PX1 or a normal pixel of the first display area DA1. The first pixel driver PC1 and the first light emitting diode ED1 may be respectively referred to as a normal pixel driver and a normal light emitting diode.

The second display area DA2 may emit light by the second light emitting diode ED2, and may include (or be distinguished into) a second-1 display area DA2-1 and a second-2 display area DA2-2. The second pixel driver PC2 may be disposed in the second-1 display area DA2-1, and the peripheral driver DR may be disposed in the second-2 display area DA2-2. The second light emitting diode ED2 for receiving the light emitting current from the second pixel driver PC2 may be disposed in the second-1 display area DA2-1 and the second-2 display area DA2-2. The second light emitting diode ED2 may include (or be distinguished into) a second light emitting diode ED2 disposed on an upper portion of the second pixel driver PC2 and a second light emitting diode ED2 disposed on the upper portion of the peripheral driver DR. The second light emitting diode ED2 disposed on the peripheral driver DR may define the second-2 display area DA2-2, and may receive a light emitting current from at least part of the second pixel driver PC2 disposed in the second-1 display area DA2-1. For example, the second pixel driver PC2 may be intone of either a second pixel driver PC2 for outputting and transmitting it to the second light emitting diode ED2 defining the second-1 display area DA2-1 and a second pixel driver PC2 for outputting and transmitting it to the second light emitting diode ED2 defining the second-2 display area DA2-2. Further, a second pixel driver PC2 may transmit an output current to the second light emitting diodes ED2, and at least one of the second light emitting diodes ED2 may be disposed in the second-2 display area DA2-2 and may be disposed on the upper portion of the peripheral driver DR. The second light emitting diodes ED2 electrically connected to a second pixel driver PC2 may be electrically connected to each other in series as shown in FIG. 4.

Regarding the light emitting display device according to a comparative example, the pixel driver and the light emitting diode may be disposed in the display area, and the light emitting diode may not be disposed in the region in which the peripheral driver is disposed. Hence, the region in which the peripheral driver is disposed may display no images, and a dead space may be formed therein. On the contrary, regarding the light emitting display device according to an embodiment, part of the second light emitting diode ED2 may be disposed on a portion on which the peripheral driver DR is disposed to display images, thereby increasing the display area displaying a screen. For example, the second light emitting diode ED2 may be disposed on the peripheral driver DR, thereby reducing the dead space and reducing the region in which no images are displayed.

The light emitting diodes ED1 and ED2, a circuit structure of the first pixel driver PC1, and a circuit structure of the second pixel driver PC2 will now be described in detail with reference to FIGS. 3 and 4.

FIGS. 3 and 4 illustrate schematic diagrams of equivalent circuits of pixels disposed on different regions included in a light emitting display device according to an embodiment.

A circuit configuration of a pixel disposed in a first display area DA1 according to an embodiment will now be described with reference to FIG. 3.

FIG. 3 illustrates a schematic diagram of an equivalent circuit of a pixel (referred to as a first pixel PX1 or a normal pixel) formed in the first display area DA1.

The first pixel PX1 shown in FIG. 3 may include transistors T1, T2, T3, T4, T5, T6, and T7 electrically connected to wires, a first capacitor Cst (referred to as a storage capacitor), two boost capacitors Cboost and Nboost, and a first light emitting diode ED1. The first light emitting diode ED1 may include an anode and a cathode, and the transistors and the capacitors may configure a pixel driver. For example, a pixel may be distinguished into a light emitting diode and a pixel driver. In some embodiments, at least one of the boost capacitors Cboost and Nboost may be omitted.

Wires may be electrically connected to a pixel PX. The wires may include a first initialization voltage line for applying a first initialization voltage VINT, a second initialization voltage line for applying a second initialization voltage VAINT, a first scan line for applying a first scan signal GW[N], a second scan line for applying a second scan signal GC[N], an initialization control line for applying an initialization signal GI[N], a light emitting control line for applying a light-emitting control signal EM[N], a data line for applying a data voltage DATA, a first voltage line for applying a first voltage ELVDD (also referred to as a driving voltage), and a second voltage line for applying a second voltage ELVSS (also referred to as a low driving voltage). In an embodiment of FIG. 3, a scan line (also referred to as a third scan line) electrically connected to the seventh transistor T7 may receive a bypass control signal GB[N], and the bypass control signal GB[N] may be substantially a same signal as the first scan line electrically connected to the second transistor T2 of a previous-stage pixel.

The first scan line may be electrically connected to the scan signal generator and may transmit the first scan signal GW[N] to the second transistor T2. A voltage with an opposite polarity to a voltage applied to the first scan line may be applied through the second scan line at a same timing as the signal of the first scan line. For example, in case that a voltage with a negative polarity is applied to the first scan line, a voltage with a positive polarity may be applied to the second scan line. The second scan line may transmit the second scan signal GC[N] to the third transistor T3. The initialization control line may transmit the initialization control signal GI[N] to the fourth transistor T4. The light emitting control line may transmit the light-emitting control signal EM[N] to the fifth transistor T5 and the sixth transistor T6. The third scan line may transmit the bypass control signal GB[N] to the seventh transistor T7.

The data line may transmit a data voltage DATA generated by a data driver (not shown), and by this, the light emitting current transmitted to the light emitting diode may be changed and luminance of light emitted by the light emitting diode may also be changed. The first voltage line may apply the first voltage ELVDD. The first initialization voltage line may transmit the first initialization voltage VINT, and the second initialization voltage line may transmit a second initialization voltage VAINT. The second voltage line may apply the second voltage ELVSS to a cathode of the light emitting diode. Constant voltages may be respectively applied to the first and second voltage lines and the first and second initialization voltage lines.

The driving transistor (or a first transistor) T1 may be a p-type transistor, and may have a silicon semiconductor or a polycrystalline semiconductor as a semiconductor layer. The driving transistor T1 may adjust the light emitting current output to the anode of the light emitting diode according to the voltage (e.g., a voltage stored in the first capacitor Cst) at a gate electrode of the driving transistor T1. As brightness of the light emitting diode is adjusted according to the light emitting current output to the anode of the light emitting diode, light emitting luminance of the light emitting diode may be adjusted according to the data voltage DATA applied to the pixel. For this purpose, a first electrode of the driving transistor T1 may be disposed to receive the first voltage ELVDD, and may be electrically connected to the first voltage line through the fifth transistor T5. The first electrode of the driving transistor T1 may be electrically connected to a second electrode of the second transistor T2 to receive the data voltage DATA. A second electrode of the driving transistor T1 may output a light emitting current to the light emitting diode, and may be electrically connected to the anode of the light emitting diode through the sixth transistor T6 (also referred to as an output control transistor). The second electrode of the driving transistor T1 may be electrically connected to the third transistor T3 to transmit the data voltage DATA applied to the first electrode to the third transistor T3. The gate electrode of the driving transistor T1 may be electrically connected to an electrode of the first capacitor Cst. Hence, the voltage at the gate electrode of the driving transistor T1 may be changed according to the voltage stored in the first capacitor Cst, and the light emitting current output by the driving transistor T1 may be changed. The first capacitor Cst may maintain the voltage at the gate electrode of the driving transistor T1 for a frame. The gate electrode of the driving transistor T1 may also be electrically connected to the third transistor T3 so that the data voltage DATA applied to the first electrode of the driving transistor T1 may pass through the third transistor T3 and may be transmitted to the gate electrode of the driving transistor T1. The gate electrode of the driving transistor T1 may be electrically connected to the fourth transistor T4 to receive the first initialization voltage VINT and may be initialized.

The gate electrode of the driving transistor T1 may be electrically connected to a first end of the first boost capacitor Cboost. The first boost capacitor Cboost may, in case that the first scan signal GW[N] is changed, allow the voltage at the gate electrode of the driving transistor T1 to be changed in a same direction. The gate electrode of the driving transistor T1 may be electrically connected to a first end of the second boost capacitor Nboost. The second boost capacitor Nboost may, in case that the second scan signal GC[N] is changed, allow the voltage at the gate electrode of the driving transistor T1 to be changed in a same direction. However, in case that the voltages of the first scan signal GW[N] and the second scan signal GC[N] are changed in opposite directions at a same timing, the two boost capacitors Cboost and Nboost may compensate each other and the voltage at the gate electrode of the driving transistor T1 may not be substantially changed.

The second transistor T2 may be a p-type transistor, and may have a silicon semiconductor or a polycrystalline semiconductor as a semiconductor layer. The second transistor T2 may receive the data voltage DATA into the pixel. The gate electrode of the second transistor T2 may be electrically connected to the first scan line and an electrode of the first boost capacitor Cboost. A first electrode of the second transistor T2 may be electrically connected to a data line. A second electrode of the second transistor T2 may be electrically connected to the first electrode of the driving transistor T1. In case that the second transistor T2 is turned on by the voltage with a negative polarity of the first scan signal GW[N] transmitted through the first scan line, the data voltage DATA transmitted through the data line may be transmitted to the first electrode of the driving transistor T1, and the data voltage DATA may be transmitted to the gate electrode of the driving transistor T1 and may be stored in the first capacitor Cst.

The third transistor T3 may be an n-type transistor, and may have an oxide semiconductor as a semiconductor layer. The third transistor T3 may electrically connect the second electrode of the driving transistor T1 and the gate electrode of the driving transistor T1. As a result, in case that the data voltage DATA is compensated by a threshold voltage of the driving transistor T1, the third transistor T3 may store the compensated data voltage DATA in a second storage electrode of the first capacitor Cst. A gate electrode of the third transistor T3 may be electrically connected to the second scan line and an electrode of the second boost capacitor Nboost, and a first electrode of the third transistor T3 may be electrically connected to the second electrode of the driving transistor T1. A second electrode of the third transistor T3 may be electrically connected to the second storage electrode of the first capacitor Cst, the gate electrode of the driving transistor T1, and other electrodes of the first boost capacitor Cboost and the second boost capacitor Nboost. The third transistor T3 may be turned on by the voltage with a positive polarity of the second scan signal GC[N] received through the second scan line, may electrically connect the gate electrode of the driving transistor T1 and the second electrode of the driving transistor T1, may transmit the voltage applied to the gate electrode of the driving transistor T1 to the second storage electrode of the first capacitor Cst, and may store the voltage in the first capacitor Cst. As the voltage stored in the first capacitor Cst, the voltage at the gate electrode of the driving transistor T1 in case that the driving transistor T1 is turned off may be stored with a threshold voltage value (Vth) of the driving transistor T1 compensated.

The fourth transistor T4 may be an n-type transistor, and may have an oxide semiconductor as a semiconductor layer. The fourth transistor T4 may initialize the gate electrode of the driving transistor T1 and the second storage electrode of the first capacitor Cst. A gate electrode of the fourth transistor T4 may be electrically connected to the initialization control line, and a first electrode of the fourth transistor T4 may be electrically connected to a first initialization voltage line. A second electrode of the fourth transistor T4 may be electrically connected to the second electrode of the third transistor T3, the second storage electrode of the first capacitor Cst, the gate electrode of the driving transistor T1, another electrode of the first boost capacitor Cboost, and another electrode of the second boost capacitor Nboost. The fourth transistor T4 may be turned on by the voltage with a positive polarity of the initialization control signal GI[N] received through the initialization control line, and it may transmit the first initialization voltage VINT to the gate electrode of the driving transistor T1, the second storage electrode of the first capacitor Cst, and an upper boost electrode of the first boost capacitor Cboost to initialize the same.

The fifth transistor T5 and the sixth transistor T6 may be p-type transistors, and may have a silicon semiconductor or a polycrystalline semiconductor as a semiconductor layer.

The fifth transistor T5 may transmit the first voltage ELVDD to the driving transistor T1. A gate electrode of the fifth transistor T5 may be electrically connected to the light emitting control line, a first electrode of the fifth transistor T5 may be electrically connected to the first voltage line, and a second electrode of the fifth transistor T5 may be electrically connected to the first electrode of the driving transistor T1.

The sixth transistor T6 may transmit the light emitting current output by the driving transistor T1 to the light emitting diode. A gate electrode of the sixth transistor T6 may be electrically connected to the light emitting control line, a first electrode of the sixth transistor T6 may be electrically connected to the second electrode of the driving transistor T1, and a second electrode of the sixth transistor T6 may be electrically connected to the anode of the light emitting diode.

The fifth transistor T5 and the sixth transistor T6 may be turned on by the voltage with a negative polarity of the light emitting control line, and may electrically connect the first voltage ELVDD, the driving transistor T1, and the first light emitting diode ED1 so that the output current may be transmitted to the first light emitting diode ED1.

The seventh transistor T7 may be a p-type transistor, and may have a silicon semiconductor (or a polycrystalline semiconductor) or an oxide semiconductor as a semiconductor layer. The seventh transistor T7 may initialize the anode of the light emitting diode. A gate electrode of the seventh transistor T7 may be electrically connected to the first scan line, a first electrode of the seventh transistor T7 may be electrically connected to the anode of the light emitting diode, and a second electrode of the seventh transistor T7 may be electrically connected to the second initialization voltage line. In case that the seventh transistor T7 is turned on by the voltage with a negative polarity of a bypass control line, the second initialization voltage VAINT may be applied to the anode of the light emitting diode and may be initialized. Further, in some embodiments, the second initialization voltage line for applying the second initialization voltage VAINT may be substantially the same as the first initialization voltage line for applying the first initialization voltage VINT.

It has been described that a pixel PX may include the first light emitting diode ED1, the seven transistors T1 to T7, and the three capacitors Cst, Cboost, and Nboost, and without being limited thereto, in some embodiments, the first boost capacitor Cboost and/or the second boost capacitor Nboost may be excluded (or omitted). It has been described that the third transistor and the fourth transistor are n-type transistors according to an embodiment, but one of them may be an n-type transistor or the other thereof may be an n-type transistor. For example, the seventh transistor T7 may be made as an n-type transistor. In some embodiments, all transistors may be n-type transistors.

The circuit structure of the first pixel PX1 formed in the first display area DA1 has been described.

A pixel structure of a second pixel PX2 formed in the second display area DA2 will now be described with reference to FIG. 4.

The second pixel PX2 formed in the second display area DA2 may include two light emitting diodes ED2m and ED2c and a second pixel driver PC2.

The second pixel driver PC2 and the first pixel driver PC1 may have a same circuit structure. The sizes of the respective corresponding transistors and capacitors included in the two pixel drivers PC1 and PC2 may be the same. However, in some embodiments, the sizes of at least one of the respective corresponding transistors and at least one of the respective corresponding capacitors included in the two pixel drivers PC1 and PC2 may be different from each other.

The second light emitting diode ED2 included in the second pixel PX2 formed in the second display area DA2 may include two light emitting diodes ED2m and ED2c electrically connected in series. Thus, the second pixel PX2 and the first pixel PX1 including a first light emitting diode ED1 may have different circuit structures. In case that the two light emitting diodes ED2m and ED2c are electrically connected in series, a cathode of one light emitting diode is electrically connected to an anode of another light emitting diode. For example, the cathode of the second-1 light emitting diode ED2m may be electrically connected to the anode of the second-2 light emitting diode ED2c. The second-1 light emitting diode ED2m may also be referred to as a main light emitting diode. The anode of the second-1 light emitting diode ED2m may receive the output current from the driving transistor T1 of the second pixel driver PC2, and the second voltage ELVSS may be applied to the cathode of the second-2 light emitting diode ED2c. The second-1 light emitting diode ED2m may also be referred to as an additional light emitting diode. The output current output by the driving transistor T1 may be applied to the two light emitting diodes ED2m and ED2c electrically connected in series which may emit light with luminance that corresponds to an output current.

For example, regarding the second pixel PX2 formed in the second display area DA2 of the light emitting display device according to an embodiment of FIG. 4, two light emitting diodes ED2m and ED2c may be electrically connected to a second pixel driver PC2, and the two light emitting diodes ED2m and ED2c may emit light with the output current of a driving transistor T1.

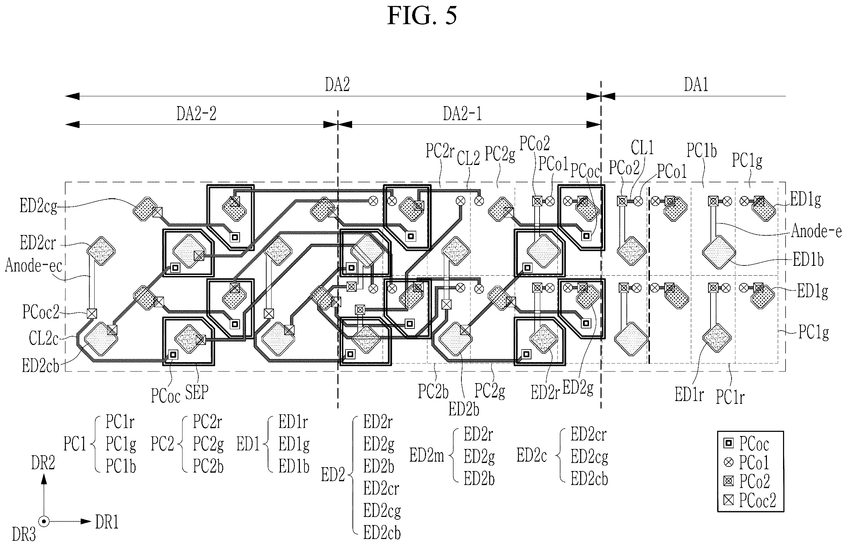

Multiple second pixels PX2 may be formed or disposed in the second display area DA2, and a connection relationship between the light emitting diodes and the second pixel driver PC2 according to an embodiment will now be described with reference to FIG. 5.

FIG. 5 illustrates a schematic plan view of a connection between a pixel driver and a light emitting diode according to an embodiment.

FIG. 5 illustrates a region disposed near the non-display area PA, of the display area DA, the second display area DA2 may be disposed near the non-display area PA, and the first display area DA1 may be disposed therein.

The first pixel PX1 included in the first display area DA1 may include a first light emitting diode ED1 and a first pixel driver PC1 for supplying a current thereto, and the second pixel PX2 included in the second display area DA2 may include a second light emitting diode ED2 and a second pixel driver PC2 for supplying a current thereto.

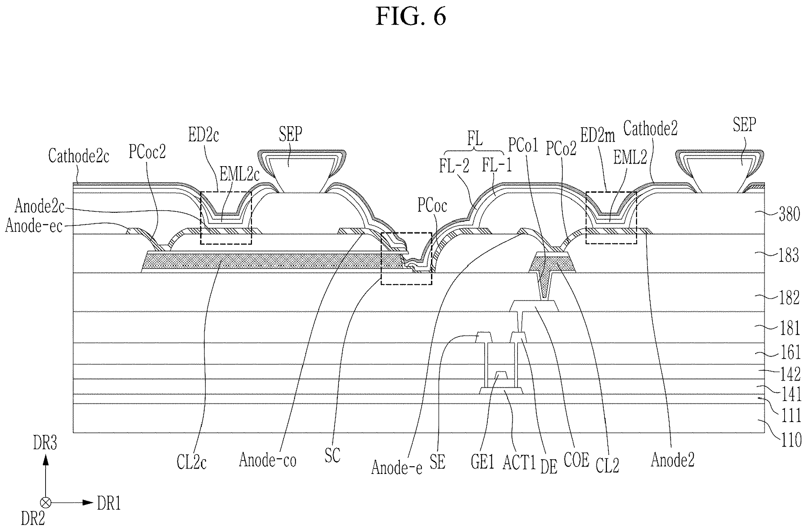

As illustrated in FIG. 5, the second display area DA2 may be divided into (or include) two regions by a dotted line, and the second pixel driver PC2 may be disposed in the second-1 display area DA2-1 disposed near the first display area DA1 and may overlap the second light emitting diode ED2 and the second pixel driver PC2 in a plan view. The peripheral driver DR may be disposed, and the second pixel driver PC2 may not be disposed, in the second-2 display area DA2-2 that is distant from the first display area DA1. The second-2 display area DA2-2 may be a region in which the second light emitting diode ED2 does not overlap the second pixel driver PC2 in a plan view. The light emitting diode may correspond to an emission layer EMI,2 and EMI,2c (refer to FIG. 6) disposed in an opening of a pixel defining layer 380 (refer to FIG. 6). Therefore, the second-2 display area DA2-2 may be a region in which the emission layer EMI,2c (refer to FIG. 6) disposed in the opening of the pixel defining layer 380 (refer to FIG. 6) does not overlap the second pixel driver PC2 in a plan view. The second-1 display area DA2-1 may be a region in which the emission layer EMI,2 (refer to FIG. 6) disposed in the opening of the pixel defining layer 380 (refer to FIG. 6) overlaps the second pixel driver PC2 in a plan view. The first display area DA1 may also be a region in which the emission layer disposed in the opening of the pixel defining layer 380 (refer to FIG. 6) may overlap the first pixel driver PC1 in a plan view.

The first pixel driver PC1 and the first light emitting diode ED1 may be disposed in the first display area DA1 of FIG. 5. The first pixel driver PC1 may be electrically connected to the first light emitting diode ED1 disposed on a top side of the first pixel driver PC1 and may supply the output current to the first light emitting diode ED1. The region emitting light by the first light emitting diode ED1 may correspond to the first display area DA1.

The second display area DA2 of FIG. 5 may emit light by the second light emitting diode ED2, and the second pixel driver PC2, the second light emitting diode ED2, and the peripheral driver DR may be disposed therein. The second pixel driver PC2 may be electrically connected to the second light emitting diode ED2 and may supply a current to the second light emitting diode ED2. The region emitting light by the second light emitting diode ED2 may correspond to the second display area DA2. The second light emitting diode ED2 disposed in the second display area DA2 may be divided into (or include) a second light emitting diode ED2 disposed on the second pixel driver PC2 and a second light emitting diode ED2 disposed on the peripheral driver such as the scan signal generator.

According to the above-described structure, as the second light emitting diode ED2 may be disposed in the region in which the peripheral driver is formed, the display area DA with an increased area may be formed. In some embodiments, a pixel driver may be electrically connected to at least one scan line so as to generate a more accurate current and provide it to the light emitting diode, and in this instance, the area of the scan signal generator may increase. However, the second light emitting diode ED2 may be disposed on the peripheral driver such as the scan signal generator so as to be included in the display area DA. Thus, the display area DA may be prevented from being reduced, and a larger display area DA may be provided.

The areas of the respective first pixel drivers PC1 may be substantially equal to the areas of the respective second pixel drivers PC2, the sizes (widths and lengths of channels) of the transistors may be substantially equal to each other, and the capacitances of the capacitors may be substantially equal to each other. However, in some embodiments, the areas of the respective first pixel drivers PC1 may be different from the areas of the respective second pixel drivers PC2. In case that the areas of the second pixel drivers PC2 are greater than the areas of the first pixel driver PC1, and they have a same circuit structure and planar shape, the areas in which the respective transistors and capacitors are formed may be larger as well so the sizes (widths and lengths of the channels) of the transistors and the capacitances of the capacitors may be larger.

The first light emitting diode ED1 and the second light emitting diode ED2 may display red (R), green (G), and blue (B). The letters "r," "g," and "b" are added to reference numerals to clarify which colors the light emitting diodes display. For example, the letters "r," "g," and "b" are added after the reference numerals such as the first pixel driver PC1 and the second pixel driver PC2 electrically connected to the corresponding light emitting diode for better distinction.

A wire for electrically connecting the pixel driver and the light emitting diode is marked with the reference numeral CL (hereinafter also referred to as an anode connecting line), an anode connecting line disposed in the first display area DA1 is shown to be a first anode connecting line CL1, and an anode connecting line disposed in the second display area DA2 is distinguished into a second anode connecting line CL2 electrically connected to the anode of the second-1 light emitting diode ED2m and a second auxiliary anode connecting line CL2c (hereinafter also referred to as an auxiliary anode connecting line) electrically connected to the anode of the second-2 light emitting diode ED2c.

Contact holes may be distinguished, and the contact hole electrically connected to one side of the anode connecting line, e.g., the contact hole electrically connected to the pixel drivers PC1 and PC2, is marked as PCo1. The contact holes for electrically connecting other sides of the anode connecting lines CL1, CL2, and CL2c and the anode of the light emitting diode are marked as PCo2 and PCoc2, the contact hole PCo2 may be electrically connected to the anodes of the light emitting diodes (the first light emitting diode ED1 and the second-1 light emitting diode ED2m) electrically connected to the pixel driver, and the contact hole PCoc2 may be electrically connected to the anode of the additional light emitting diode (or the second-2 light emitting diode ED2c). A contact hole PCoc may be electrically connected to a first end of the second auxiliary anode connecting line CL2c, and a second end of the second auxiliary anode connecting line CL2c may be electrically connected to the anode of the second-2 light emitting diode ED2c through the contact hole PCoc2. The contact hole PCoc may electrically connect the cathode of the second-1 light emitting diode ED2m and the second auxiliary anode connecting line CL2c according to a side-contact (SC) method as shown in FIG. 6.

The anode of the first light emitting diode ED1 and the anode of the second-1 light emitting diode ED2m may respectively have an extension Anode-e to be thus respectively electrically connected to the first anode connecting line CL1 and the second anode connecting line CL2. The anode of the second-2 light emitting diode ED2c may have an extension Anode-ec and may be electrically connected to the second auxiliary anode connecting line CL2c.

A separator SEP may have a polygonal shape in a plan view. The separator SEP may protrude upward and may be inversely tapered, which will be described below with reference to FIG. 6. Cathodes disposed on respective sides of the separator SEP may be electrically separated from each other.

Regarding the first display area DA1, the first light emitting diode ED1 of respective colors and the first pixel driver PC1 overlapping the first light emitting diode ED1 in a plan view may be electrically connected to each other, and the extension Anode-e of the anode of the first light emitting diode ED1 may be electrically connected to the first anode connecting line CL1 through the contact hole PCo2, and the first anode connecting line CL1 may be electrically connected to the first pixel driver PC1 through the contact hole PCo1.

A connection structure of the second display area DA2 will now be described in detail.

FIG. 5 illustrates twelve second pixel drivers PC2, and twenty-four second light emitting diodes ED2 so that the number of the second light emitting diodes ED2 are twice the number of the second pixel drivers PC2. For example, one second pixel driver PC2 may supply the current to two second light emitting diodes ED2. One of the two second light emitting diodes ED2 may be a second-1 light emitting diode ED2m and may receive the output current from the second pixel driver PC2, and the other may be a second-2 light emitting diode ED2c and may receive the output current from the cathode of the second-1 light emitting diode ED2m. The extension Anode-e of the anode of the second-1 light emitting diode ED2m may be electrically connected to the second anode connecting line CL2 through the contact hole PCo2, and the second anode connecting line CL2 may be electrically connected to the second pixel driver PC2 through the contact hole PCo1. The cathode of the second-1 light emitting diode ED2m may be electrically separated (or electrically disconnected) by the separator SEP. The cathode of the second-1 light emitting diode ED2m may be electrically connected to the second auxiliary anode connecting line CL2c by the contact hole PCoc. The second auxiliary anode connecting line CL2c may be electrically connected to the extension Anode-ec of the anode of the second-2 light emitting diode ED2c through the contact hole PCoc2. As a result, the output current provided by the second pixel driver PC2 may be input to the anode of the second-1 light emitting diode ED2m, may pass through the cathode of the second-1 light emitting diode ED2m, and may be transmitted to the anode of the second-2 light emitting diode ED2c.

A detailed cross-sectional structure will now be described with reference to FIG. 6.

FIG. 6 illustrates a schematic cross-sectional view of a connection of a light emitting diode according to an embodiment of FIG. 5.

FIG. 6 illustrates a schematic cross-sectional view of second light emitting diodes ED2m and ED2c electrically connected in series, illustrating one transistor by simplifying a structure disposed on lower portions of planarization films 181, 182, and 183. The light emitting diode described with reference to FIG. 5 may correspond to a planar structure of the emission layer disposed in the opening of the pixel defining layer 380, and the light emitting diode may further include an anode and a cathode disposed above/below the emission layer. The anode may be disposed on the lower portion/upper portion of the emission layer, and the cathode may be disposed on an opposite side to the anode. Therefore, the anode and the cathode may also be referred to as a first electrode and a second electrode. The first electrode, the pixel defining layer, the intermediate layer (including the emission layer), and the second electrode may be referred to as a light emitting diode layer in a cross-sectional view, and the conductive layer configuring a transistor and a capacitor, the semiconductor layer, and the insulating layer disposed on the lower portion of the light emitting diode layer may be referred to as a driving device layer.

A structure from the substrate 110 to the planarization films 181, 182, and 183, e.g., the structure of the driving device layer, will now be described.

The first substrate 110 may include a material that has a rigid characteristic such as glass and is not bent, or may include a flexible material that is bent such as plastic or a polyimide. The flexible substrate may have a structure in which a double layer including a polyimide and a barrier layer made of (or including) an inorganic insulating material is repeatedly formed.

A buffer layer 111 may be disposed on the first substrate 110 to cover the same. The buffer layer 111 may block permeation of impurities into a first semiconductor layer ACT1, and it may be an inorganic insulating layer including, e.g., at least one of a silicon oxide (SiOx), a silicon nitride (SiNx), and a silicon oxynitride (SiOₓN_{y}).

In some embodiments, a lower shielding layer overlapping the channel of the transistor and including a metal may be further included between the first substrate 110 and the buffer layer 111.

A first semiconductor layer ACT1 made of a silicon semiconductor (e.g., a polycrystalline semiconductor (P-Si)) may be disposed on the buffer layer 111. The first semiconductor layer ACT1 may include a channel of a polycrystalline silicon transistor including a driving transistor and a first region and a second region disposed on respective sides of the channel. The polycrystalline silicon transistor may be other types of switching transistors in addition to the driving transistor. The respective sides of the channel of the first semiconductor layer ACT1 may have a region that has a conductive layer characteristic according to a plasma process or a doping process to function as the first electrode and the second electrode of the transistor.

A first gate insulating layer 141 may be disposed on the first semiconductor layer ACT1. The first gate insulating layer 141 may be an inorganic insulating layer including, e.g., at least one of a silicon oxide (SiOx), a silicon nitride (SiNx), and a silicon oxynitride (SiOₓN_{y}).

A first gate conductive layer including a gate electrode GE1 of the polycrystalline silicon transistor may be disposed on the first gate insulating layer 141. A scan line or a light emitting control line in addition to the gate electrode GE1 of the polycrystalline silicon transistor may be formed on the first gate conductive layer.

In case that the first gate conductive layer is formed, the exposed region of the first semiconductor layer may be made conductive by performing a plasma process or a doping process. For example, the first semiconductor layer ACT1 covered by the gate electrode GE1 may not be made into a conductor, and a portion of the first semiconductor layer ACT1 not covered by the gate electrode GE1 may have substantially the same characteristic as the conductive layer.

A second gate insulating layer 142 may be disposed on the first gate conductive layer and the first gate insulating layer 141. The second gate insulating layer 142 may be an inorganic insulating layer including, e.g., at least one of a silicon oxide (SiOₓ), a silicon nitride (SiNx), and a silicon oxynitride (SiOₓN_{y}).

A second gate conductive layer including one electrode of the first capacitor Cst may be disposed on the second gate insulating layer 142, which is not shown in FIG. 6. The one electrode of the first capacitor Cst may overlap the gate electrode GE1 of the driving transistor to configure the first capacitor Cst.

A first interlayer insulating layer 161 may be disposed on the second gate conductive layer. The first interlayer insulating layer 161 may include an inorganic insulating layer including a silicon oxide (SiOx), a silicon nitride (SiNx), or a silicon oxynitride (SiOₓN_{y}), and in some embodiments, the inorganic insulating material may be made thick.

A first data conductive layer including connecting members SE and DE electrically connected to the first region and the second region of the polycrystalline silicon transistor may be disposed on the first interlayer insulating layer 161. The first data conductive layer may include a metal such as aluminum (Al), copper (Cu), molybdenum (Mo), or titanium (Ti), or metal alloys thereof, and may be a single layer or a multilayer.

Although not shown in FIG. 6, in some embodiments, an oxide transistor may be included between the first interlayer insulating layer 161 and the first data conductive layer, and the oxide transistor may have a layered structure given below.

A second semiconductor layer (or an oxide semiconductor layer) including a second semiconductor including a channel, a first region, and a second region of the oxide transistor may be disposed on the first interlayer insulating layer 161. A third gate insulating layer may be disposed on the second semiconductor layer. The third gate insulating layer may be disposed on the second semiconductor layer and a front side of the first interlayer insulating layer 161. A third gate conductive layer including a gate electrode of the oxide transistor may be disposed on the third gate insulating layer. The gate electrode of the oxide transistor may overlap a channel, and the third gate conductive layer may further include a scan line and a control line. A second interlayer insulating layer may be disposed on the third gate conductive layer.

A first planarization film 181 may be disposed on the first data conductive layer. The first planarization film 181 may be an organic insulator including an organic material, and the organic material may include, e.g., at least one material of a polyimide, a polyamide, an acryl resin, benzocyclobutene, and a phenol resin.

A second data conductive layer including a connecting member COE may be disposed on the first planarization film 181. The second data conductive layer may include a data line and a first voltage line. The second data conductive layer may include a metal such as aluminum (Al), copper (Cu), molybdenum (Mo), or titanium (Ti), or metal alloys thereof, and may be a single layer or a multilayer. The connecting member COE may be electrically connected to the connecting member DE through the opening disposed in the first planarization film 181.

A second planarization film 182 may be disposed on the second data conductive layer, and the second planarization film 182 may be an organic insulator and may include, e.g., at least one material of a polyimide, a polyamide, an acryl resin, benzocyclobutene, and a phenol resin.

A third data conductive layer including a second anode connecting line CL2 and a second auxiliary anode connecting line CL2c may be disposed on the second planarization film 182. The second anode connecting line CL2 may be electrically connected to the transistor of the pixel driver through the contact hole PCo1 disposed in the second planarization film 182 and may receive the output current. The third data conductive layer may include a metal such as aluminum (Al), copper (Cu), molybdenum (Mo), or titanium (Ti), or metal alloys thereof, and may be a single layer or a multilayer. The third data conductive layer may have a triple-layered structure, and the triple-layered structure may include a lower portion layer and an upper portion layer including titanium (Ti), and an intermediate layer including aluminum (Al) between the lower portion layer and the upper portion layer.

A third planarization film 183 may be disposed on the third data conductive layer. The third planarization film 183 may be an organic insulator, and may include, e.g., at least one material of a polyimide, a polyamide, an acryl resin, benzocyclobutene, and a phenol resin.

A light emitting diode layer may be disposed on the third planarization film 183, and anodes Anode2 and Anode2c and an auxiliary connecting member (or auxiliary connecting part) Anode-co included in the light emitting diodes ED2m and ED2c may be formed. The auxiliary connecting member Anode-co and the anodes Anode2 and Anode2c may be made of a same material.

The anode Anode2 included in the second-1 light emitting diode ED2m may have an extension Anode-e, and the extension Anode-e may be electrically connected to the second anode connecting line CL2 through the contact hole PCo2 and may receive the output current from the transistor of the pixel driver.

The anode Anode2c included in the second-2 light emitting diode ED2c may have an extension Anode-ec, and the extension Anode-ec may be electrically connected to the second auxiliary anode connecting line CL2c through the contact hole PCoc2.

The auxiliary connecting member Anode-co may be disposed near the contact hole PCoc, and may help electrically connect a cathode Cathode2 and the second auxiliary anode connecting line CL2c through the contact hole PCoc. In case that wet etching is performed to form the anode, particles of silver (Ag) may be reduced/precipitated near the third data conductive layer including exposed aluminum (Al), defects may be generated from the auxiliary connecting member Anode-co for a subsequent process, and hence, generation of the particles of silver (Ag) may be prevented and the defects may be removed by forming the auxiliary connecting member Anode-co that is an anode material. In an embodiment that does not have the above-noted problem, the auxiliary connecting member Anode-co may be omitted in case that there is no problem in electrically connecting the cathode Cathode2 and the second auxiliary anode connecting line CL2c.

A pixel defining layer 380 having openings for exposing the anodes Anode2 and Anode2c and the auxiliary connecting member Anode-co and covering at *least parts* of the anodes Anode2 and Anode2c and the auxiliary connecting member Anode-co may be disposed on the anodes Anode2 and Anode2c and the auxiliary connecting member Anode-co. The pixel defining layer 380 may be a black pixel defining layer made of a black organic material and preventing light applied from the outside from being reflected to the outside, and in some embodiments, it may be made of a transparent organic material. The opening for exposing the anodes Anode2 and Anode2c of the pixel defining layer 380 may correspond to the light emitting diodes ED2m and ED2c, and a border of the opening of the pixel defining layer 380 may correspond to a border of the light emitting diodes ED2m and ED2c in a plan view.

A separator SEP may be disposed on the pixel defining layer 380. The separator SEP may have an inversely tapered side wall so that the layer disposed on an upper portion of the separator SEP may be electrically disconnected near the separator SEP. For example, FIG. 6 illustrates that a functional layer FL and the cathode Cathode2 disposed on the upper portion of the separator SEP are separated from the inversely tapered side wall. As a result, the cathode Cathode2 may be electrically separated (or electrically disconnected) with respect to the separator SEP. The separator SEP and the pixel defining layer 380 may be made of a same material, or may be made of different materials according to another process.

A first functional layer FL-1 may be disposed on the pixel defining layer 380 and the separator SEP, and the first functional layer FL-1 may be electrically disconnected around the separator SEP.

Emission layers EML2 and EMI,2c may be respectively disposed on the anodes Anode2 and Anode2c, may be disposed on the first functional layer FL-1, and may be exposed in the opening of the pixel defining layer 380.

A second functional layer FL-2 may be disposed on the first functional layer FL-1 and the emission layers EML2 and EMI,2c, and the second functional layer FL-2 may be electrically disconnected around the separator SEP.

The first functional layer FL-1 may contact the second functional layer FL-2 near or in a portion where the emission layers EMI,2 and EML2c are not disposed.

The cathodes Cathode2 and Cathode2c may be disposed on the second functional layer FL-2, and may be separated with respect to the separator SEP to configure the cathode Cathode2 of the second-1 light emitting diode ED2m and the cathode Cathode2c of the second-2 light emitting diode ED2c.

A combination of the functional layer FL and the emission layer EML2 and EMI,2c may be referred to as an intermediate layer. The functional layer FL may include at least one of auxiliary layers including an electron injection layer, an electron transport layer, a hole transport layer, and a hole injection layer, the first functional layer FL-1 disposed on the lower portions of the emission layers EMI,2 and EMI,2c may include a hole injection layer and/or a hole transport layer, and the second functional layer FL-2 disposed on the upper portions of the emission layers EMI,2 and EMI,2c may include an electron transport layer and/or an electron injection layer.

The second-1 light emitting diode ED2m may include an anode Anode2, an emission layer EML2, and a cathode Cathode2, and may further include a first functional layer FL-1 disposed between the anode Anode2 and the emission layer EMI,2 and a second functional layer FL-2 disposed between the emission layer EML2 and the cathode Cathode2.

The second-2 light emitting diode ED2c may include an anode Anode2c, an emission layer EMI,2c, and a cathode Cathode2c, and may further include a first functional layer FL-1 disposed between the anode Anode2c and the emission layer EMI,2c and a second functional layer FL-2 disposed between the emission layer EMI,2c and the cathode Cathode2c.

At least a portion of the cathode Cathode2 of the second-1 light emitting diode ED2m and the functional layer FL disposed below the same may overlap the auxiliary connecting member Anode-co, and may be electrically connected to the second auxiliary anode connecting line CL2c through the contact hole PCoc. In the embodiment of FIG. 6, the second auxiliary anode connecting line CL2c and the cathode Cathode2 of the second-1 light emitting diode ED2m may be electrically connected by a side-contact (SC) method. For example, the intermediate layer including aluminum (Al) of the triple-layered structure of the second auxiliary anode connecting line CL2c may be etched more than the lower portion layer and the upper portion layer including titanium (Ti), and the cathode Cathode2 of the second-1 light emitting diode ED2m and the intermediate layer of the second auxiliary anode connecting line CL2c may contact each other with the auxiliary connecting member Anode-co therebetween and may be electrically connected to each other. The auxiliary connecting member Anode-co may be electrically connected to the lower portion layer of the second auxiliary anode connecting line CL2c. The side-contact (SC) method of FIG. 6 may be one of electrically connecting methods according to an embodiment, but the embodiments are not limited thereto. In embodiments, various types of electrical connection methods are allowable.

The second auxiliary anode connecting line CL2c may be electrically connected to the anode Anode2c of the second-2 light emitting diode ED2c so that the cathode Cathode2 of the second-1 light emitting diode ED2m is electrically connected to the anode Anode2c of the second-2 light emitting diode ED2c and the light emitting diodes ED2m and ED2c are electrically connected in series.

In some embodiments, a spacer may be further formed on the pixel defining layer 380, and the spacer may have a tapered side wall to prevent the cathode from being electrically disconnected.

FIG. 6 illustrates no element disposed on the cathode; however in some embodiments, another layer, e.g., an encapsulation layer, may be disposed thereon. The encapsulation layer may include at least one inorganic film and at least one organic film, and may have a triple-layered structure including a first inorganic encapsulation layer, an organic encapsulation layer, and a second inorganic encapsulation layer. The encapsulation layer may protect the emission layers EMI,2 and EMI,2c from moisture or oxygen that is input from the outside. In some embodiments, the encapsulation layer may include a structure in which an inorganic layer and an organic layer are sequentially stacked each other.

In some embodiments, a sensing insulating layer and sensing electrodes may be disposed on the encapsulation layer to sense touches.

In some embodiments, a film including a polarizer may be attached to the encapsulation layer to reduce reflection of external light, or a color filter or a color converting layer may be further formed (or disposed) thereon to increase color quality. A light blocking member may be disposed between the color filter or the color converting layer.

In some embodiments, a layer on which a material (hereinafter referred to as a reflection adjusting material) for absorbing light of a wavelength (e.g., a predetermined or selectable wavelength) of external light is formed, may be further included. In some embodiments, a front side of the light emitting display device may be planarized by covering an additional planarization film.

Although FIG. 6 illustrates a cross-sectional structure according to an embodiment, structures with numerous variations are allowable. It has been described in the above-noted embodiment that the anode connecting lines such as the second anode connecting line CL2 and the second auxiliary anode connecting line CL2c are formed on the third data conductive layer. However, in some embodiments, the anode connecting lines such as the second anode connecting line CL2 and the second auxiliary anode connecting line CL2c may be disposed on another conductive layer (e.g., a second data conductive layer or a first data conductive layer), and in this instance, the conductive layer or the planarization film disposed on the upper portion on which the anode connecting lines are disposed may be omitted.

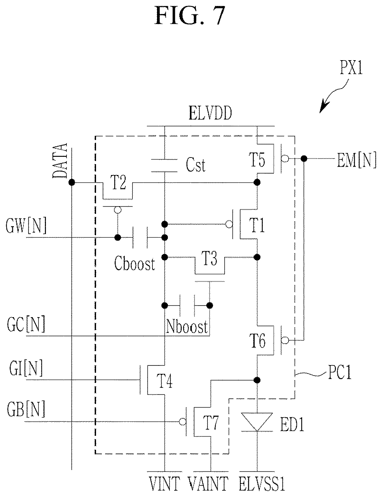

Another embodiment that is different from the embodiment of FIGS. 3 to 6 will now be described with reference to FIGS. 7 to 10.

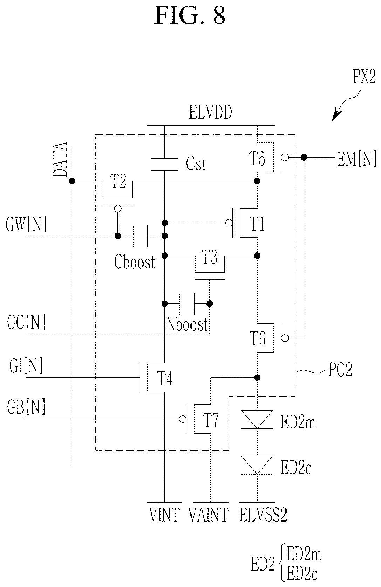

A circuit structure of a pixel will now be described with reference to FIGS. 7 and 8.

FIGS. 7 and 8 illustrate schematic diagrams of equivalent circuits of pixels disposed on different regions included in a light emitting display device according to another embodiment.

FIG. 7 illustrates the first light emitting diode ED1 and the first pixel driver PC1 formed in the first display area DA1, and FIG. 8 illustrates the second light emitting diode ED2 and the second pixel driver PC2 formed in the second display area DA2.

The embodiment of FIGS. 7 and 8 may be different from the embodiment of FIGS. 3 and 4 at least in that different second voltages are applied to the cathodes of the light emitting diodes ED1 and ED2. For example, a second-1 voltage ELVSS1 may be applied to the cathode of the first light emitting diode ED1 formed in the first display area DA1, and a second-2 voltage ELVSS2 may be applied to the cathode of the second-2 light emitting diode ED2c of the second light emitting diode ED2 formed in the second display area DA2. The second-1 voltage ELVSS1 may have a higher value than the second-2 voltage ELVSS2.

In an embodiment of FIGS. 7 and 8, as different voltages are applied to the cathode in case that the number of the light emitting diodes changes, the first pixel driver PC1 and the second pixel driver PC2 may have a same circuit structure, and the sizes of the respective transistors and the respective capacitors included in the pixel drivers PC1 and PC2 may be the same. However, in some embodiments, the sizes of some transistors or some capacitors may be different.

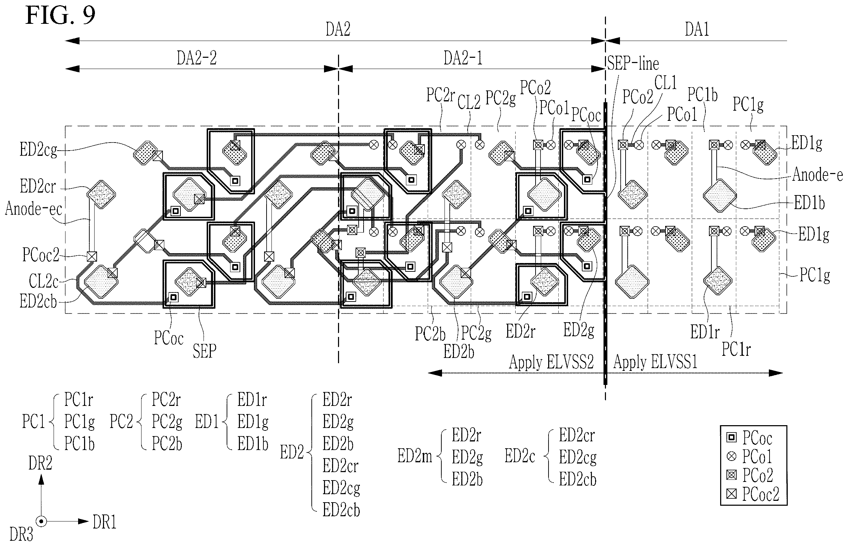

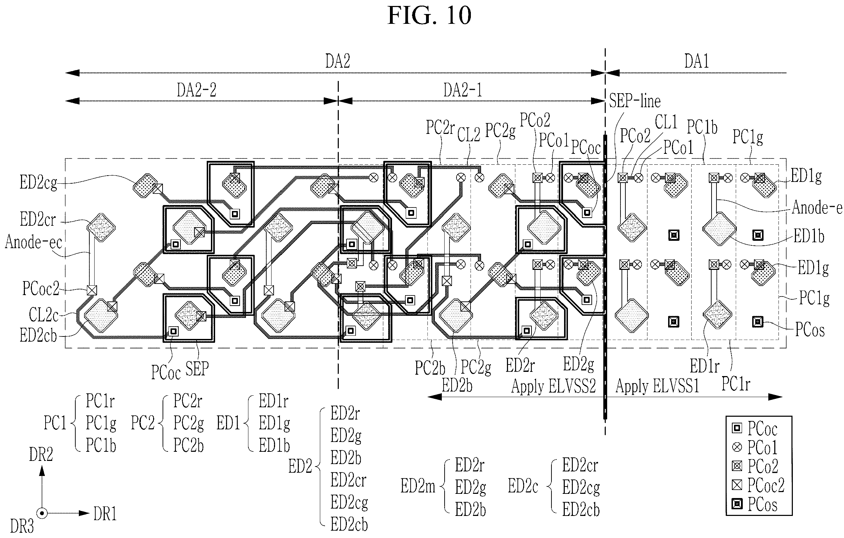

A pixel circuit according to an embodiment of FIGS. 7 and 8 may be realized with a planar structure described with reference to FIG. 9 or 10 so the planar structure shown in FIGS. 9 and 10 will now be described.

FIGS. 9 and 10 illustrate a schematic plan view of a connection between a pixel driver and a light emitting diode according to an embodiment of FIGS. 7 and 8.

The planar structure shown in FIG. 9 will now be described.

The structure shown in FIG. 9 may be similar to the planar structure of FIG. 6, and may further include an additional separator SEP-line extending in a direction (or a second direction DR2 in FIG. 9) in the structure of FIG. 6. The additional separator SEP-line may be disposed on a border between the first display area DA1 and the second display area DA2. The additional separator SEP-line may have a straight line structure extending in a direction as shown in FIG. 9. However, in some embodiments, it may have a curved structure or a stepwise structure.

The additional separator SEP-line may separate the cathodes disposed on respective sides, and the second-1 voltage ELVSS1 may be applied to the cathode disposed on a side of the additional separator SEP-line and disposed in the first display area DA1, and the second-2 voltage ELVSS2 may be applied to the cathode of the second-2 light emitting diode ED2c disposed on another side of the additional separator SEP-line and disposed in the second display area DA2. Part of the cathode disposed in the second display area DA2, for example, the cathode of the second-1 light emitting diode ED2m, may be separated by the separator SEP so the second-2 voltage ELVSS2 may not be applied thereto, and the cathode may be electrically connected to the anode of the second-2 light emitting diode ED2c.

The cathode disposed in the first display area DA1 may receive the second-1 voltage ELVSS1 from the external side of the display area DA, and the cathode of the second-2 light emitting diode ED2c may receive the second-2 voltage ELVSS2 from the external side of the display area DA. In some embodiments, the second voltages ELVSS1 and ELVSS2 applied to the respective cathodes may not be applied to the external side of the display area DA, but the respective second voltages ELVSS1 and ELVSS2 may be transmitted through a single conductive layer (e.g., a second data conductive layer or a third data conductive layer), and the respective second voltages ELVSS1 and ELVSS2 may be transmitted to the cathode through a contact hole.

FIG. 10 illustrates a transmission of a second voltage through a conductive layer according to an embodiment.

Differing from the embodiment of FIG. 8, an additional contact hole PCos may be formed in the first display area DA1 in the embodiment described with FIG. 10. The contact hole PCos may expose a second-1 voltage transmitting wire (not shown) overlapping the contact hole PCos and may connect the same to the cathode disposed in the first display area DA1 so that the second-1 voltage ELVSS1 is transmitted to the cathode disposed in the first display area DA1. For example, the second-1 voltage ELVSS1 may be transmitted through the second-1 voltage transmitting wire having a mesh structure and may be transmitted to the cathode disposed in the first display area DA1 through the contact hole PCos. In case that the second-1 voltage ELVSS1 is transmitted through the second-1 voltage transmitting wire having a mesh structure, the second-1 voltage ELVSS1 may be constant in the entire first display area DA1. According to an embodiment of FIG. 10, the second-1 voltage ELVSS1 may be applied from the external side of the display area DA.

The light emitting display device with the structure shown in FIG. 1 has been described, and the second display area DA2 may be disposed along the respective sides of the first display area DA1 according to an embodiment of FIG. 1.

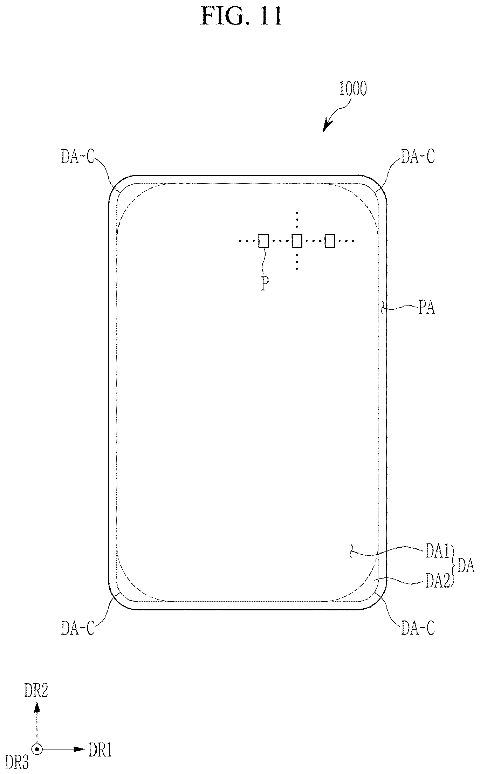

However, the second display area DA2 may be formed on positions that are different from what is shown in FIG. 1, one of which will now be described with reference to FIG. 11.

FIG. 11 illustrates a schematic plan view of a light emitting display device according to another embodiment.

Regarding the light emitting display device shown in FIG. 11, the second display area DA2 may be disposed at four corners DA-C and their peripherals, which is different from the embodiment of FIG. 1. For example, the second display area DA2 may be disposed on a portion that corresponds to the corner of the first display area DA1.

FIG. 11 illustrates that the non-display area that may be formed at the corner DA-C of the light emitting display device may be reduced and may be modified to the second display area DA2 to thus have a wider display area DA.

At least one of the embodiments of FIGS. 2 to 10 may be applied to the light emitting display device according to an embodiment described with FIG. 11. For example, part of the second display area DA2 disposed near the corner DA-C of FIG. 11 may overlap the peripheral driver as shown in FIG. 2. The embodiment of FIGS. 3 to 6 may be applied to the light emitting display device, the light emitting display device may have a pixel structure shown in FIGS. 7 and 8, or it may have the planar structure shown with FIG. 9 or 10.

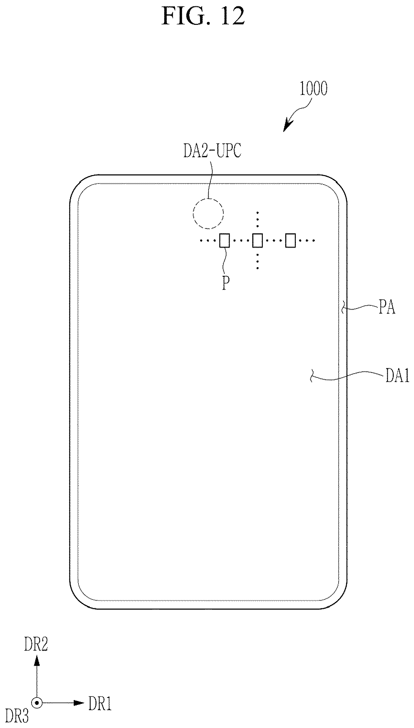

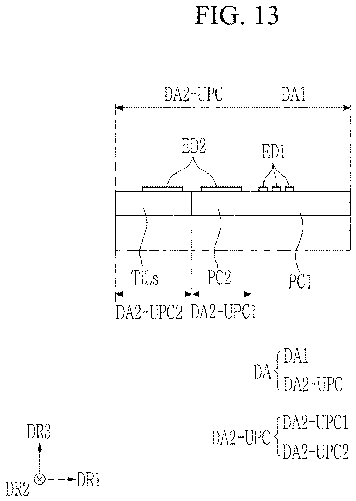

The embodiment in which the non-display area in which the additional light emitting diode is disposed around the display area is changed to the display area and the display area increases has been described, and the embodiment in which the additional light emitting diode is disposed on the upper portion of the peripheral driver for generating signals for operating the pixel has been described. However, the additional light emitting diode may be disposed on the external side of the display area, the upper portion of the peripheral driver, and other portions. An embodiment in which the additional light emitting diode is disposed in a component region DA2-UPC that corresponds to the camera disposed on the rear side will now be described with reference to FIGS. 12 and 13. The component region may be referred to as a second display area including a light transmitting area, the second display area including a light transmitting area may be surrounded by the first display area, and the light transmitting area may provide light to the camera.

FIG. 12 illustrates a schematic plan view of a light emitting display device according to another embodiment, and FIG. 13 illustrates a schematic cross-sectional view of a portion shown in FIG. 12.

The light emitting display device according to an embodiment shown in FIG. 12 may be disposed in the first display area DA1, and may include the component region DA2-UPC surrounded by the first display area DA1.

The light emitting display device may include a light emitting display panel, and a camera (not shown) may be disposed on the rear side of the component region DA2-UPC of the light emitting display panel. In some embodiments, a sensor rather than the camera may be disposed on a rear side of the component region DA2-UPC.

The component region DA2-UPC may include a region (also a light transmitting area) made of a transparent layer through which light may transmit and a pixel (also a second component pixel) for displaying images. The light transmitting area may have no conductive layer or semiconductor layer therein, and a layer including a light blocking material, for example, a pixel defining layer and/or a light blocking member, may include an opening overlapping the position that corresponds to the component region DA2-UPC. Thus, the light transmitting area may have a structure that does not block light.

A structure of the first display area DA1 may be substantially the same as the structure shown in FIGS. 1 and 2 so the structure of the component region DA2-UPC will be mainly described with reference to FIG. 13.

The component region DA2-UPC may include a second light emitting diode ED2 and a second pixel driver PC2.

The component region DA2-UPC may have a light transmitting area, it may emit light by the second light emitting diode ED2, and it may be divided into a second-1 component region DA2-UPC1 and a second-2 component region DA2-UPC2. The second pixel driver PC2 may be disposed in the second-1 component region DA2-UPC1, and the light transmitting area in which a transparent insulating layer TILs is disposed may be disposed in the second-2 component region DA2-UPC2. The transparent insulating layer TILs may include no semiconductor layer or conductive layer and may be made of a transparent insulating layer so it may not block light. In some embodiments, the light transmitting area may be disposed on the region that is not the second-1 component region DA2-UPC1 and the second-2 component region DA2-UPC2.

In the embodiment of FIG. 13, the second light emitting diode ED2 for receiving a light emitting current from the second pixel driver PC2 may be disposed in the second-1 component region DA2-UPC1 and the second-2 component region DA2-UPC2. The second light emitting diode ED2 may be distinguished into a second light emitting diode ED2 disposed on the upper portion of the second pixel driver PC2 and a second light emitting diode ED2 disposed on an upper portion of the transparent insulating layer TILs. The second light emitting diode ED2 disposed on the transparent insulating layer TILs may define the second-2 component region DA2-UPC2, and may receive a light emitting current from at least part of the second pixel driver PC2 disposed on the second-1 component region DA2-UPC1. For example, the second pixel driver PC2 may be distinguished into a second pixel driver PC2 for transmitting an output to the second light emitting diode ED2 defining the second-1 component region DA2-UPC1 and a second pixel driver PC2 for transmitting an output to the second light emitting diode ED2 defining the second-2 component region DA2-UPC2. A second pixel driver PC2 may transmit an output current to the second light emitting diodes ED2, and at least one of the second light emitting diodes ED2 may be disposed in the second-2 component region DA2-UPC2 and may be disposed on the upper portion of the transparent insulating layer TILs. The second light emitting diodes ED2 electrically connected to a second pixel driver PC2 may be electrically connected in series to each other as shown in FIG. 4.

In some embodiments, the number of pixels per area of the second component pixels may be less than the number of pixels per area of normal pixels included in the first display area DA1. As a result, the resolution of the second component pixels may be lower than the resolution of the normal pixels. A first pixel driver PC1 may be electrically connected to a first light emitting diode ED1, and a second pixel driver PC2 may be electrically connected to at least two second light emitting diodes ED2. A size of the first pixel driver PC1 may be equivalent to or different from a size of the second pixel driver PC2. For example, the size of the second pixel driver PC2 may be equal to or greater than the size of the first pixel driver PC1.

Regarding the light emitting display device according to a comparative example, no additional pixels or light emitting diodes may be formed in the region in which a camera is disposed in the display area, so that the non-display area is disposed in the display area, which is a drawback. However, in the embodiment of FIG. 12, the pixels or the light emitting diodes may be disposed in the component region DA2-UPC to display images, which therefore may have the merit that no non-display area is disposed in the display area.

The light emitting display device according to an embodiment described with reference to FIG. 12 may have the pixel circuit shown in FIGS. 3 and 4, and may have the pixel circuit shown in FIGS. 7 and 8.

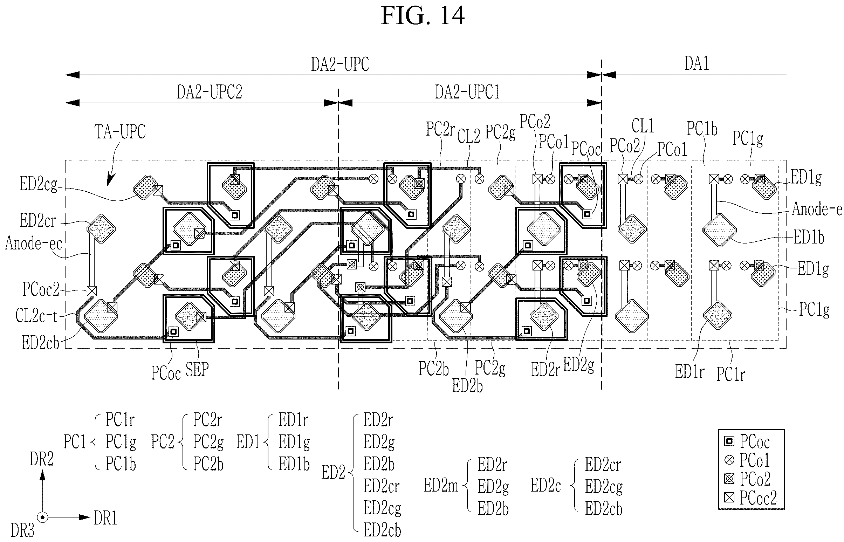

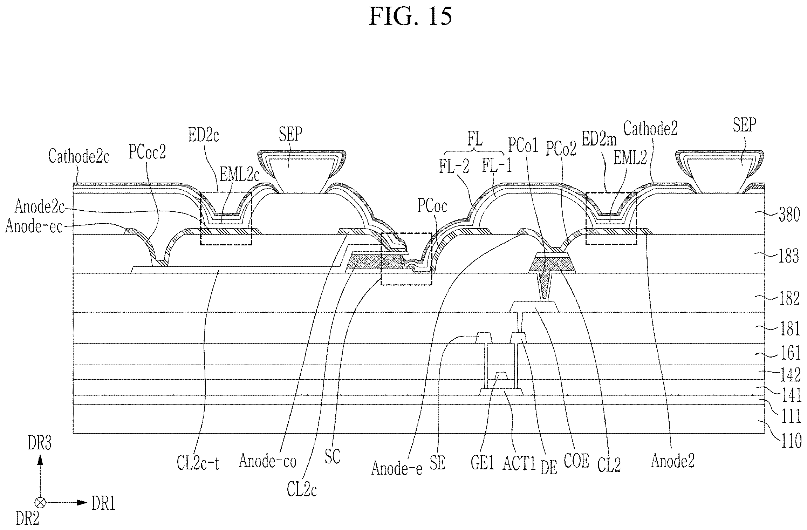

An embodiment in which the light emitting display device according to an embodiment of FIG. 12 may have the pixel circuit shown in FIGS. 3 and 4 will now be described with reference to FIGS. 14 and 15.

A planar structure will now be described with reference to FIG. 14.

FIG. 14 illustrates a schematic plan view of a connection between a pixel driver and a light emitting diode according to an embodiment of FIG. 12.

The embodiment of FIG. 14 may be similar to the embodiment of FIG. 5, but it may include a light transmitting area TA-UPC excluding the region in which the light emitting diodes ED2m and ED2c, the second anode connecting line CL2, and the contact holes PCoc and PCoc2 are disposed in the second-2 component region DA2-UPC2, differing from FIG. 5. An auxiliary anode connecting line CL2c-t may be made of a transparent conductive material and may form the wide light transmitting area TA-UPC. The camera disposed on a rear side of the light transmitting area TA-UPC may photograph or sense the front side of the light emitting display device through the light transmitting area TA-UPC.

A schematic cross-sectional structure will now be described with reference to FIG. 15.

FIG. 15 illustrates a schematic cross-sectional view of a connection of a light emitting diode according to an embodiment of FIG. 14.

Differing from what is described with FIG. 6, referring to FIG. 15, the auxiliary anode connecting line CL2c-t may be made of a transparent conductive material to have a transparent characteristic. In the embodiment of FIG. 15, the auxiliary anode connecting line CL2c-t may be formed in the second-2 component region DA2-UPC2 in which the light transmitting area TA-UPC is disposed, and the auxiliary anode connecting line CL2c-t may include a transparent conductive material so as to widen the light transmitting area TA-UPC. According to the structure of FIG. 15, the second anode connecting line CL2c and the auxiliary anode connecting line CL2c-t may be disposed on the second planarization film 182 and may be made of different materials, and this may have a drawback of using an additional mask and forming them according to another process. However, the camera may need a wider light transmitting area TA-UPC so as to photograph the front side of the light emitting display device, and this may have a technical advantage of widening the light transmitting area TA-UPC by forming the auxiliary anode connecting line CL2c-t of a transparent conductive material.

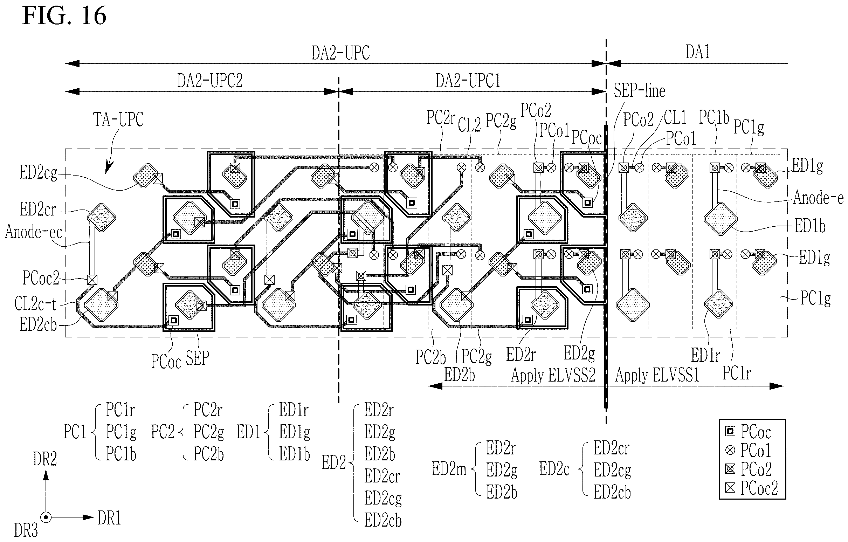

An embodiment in which the light emitting display device according to an embodiment of FIG. 12 has the pixel circuit shown in FIGS. 7 and 8 will now be described with reference to FIG. 16.

FIG. 16 illustrates a schematic plan view of a connection between a pixel driver and a light emitting diode according to an embodiment of FIG. 14.

FIG. 16 may include an additional separator SEP-line extending in a direction (a second direction DR2 in FIG. 14) in addition to FIG. 14. The additional separator SEP-line may be disposed on the border of the first display area DA1 and the component region DA2-UPC. The additional separator SEP-line may have a straight line structure extending in a direction as shown in FIG. 16, and in some embodiments, it may have a curved structure or a stepwise structure.

The additional separator SEP-line may separate the cathodes disposed on respective sides, and the second-1 voltage ELVSS1 may be applied to the cathode disposed on a side of the additional separator SEP-line and disposed in the first display area DA1, and the second-2 voltage ELVSS2 may be applied to the cathode of the second-2 light emitting diode ED2c disposed on another side of the additional separator SEP-line and disposed in the component region DA2-UPC. Part of the cathode disposed in the component region DA2-UPC, e.g., the cathode of the second-1 light emitting diode ED2m, may be separated by the separator SEP so that the second-2 voltage ELVSS2 may not be applied thereto, and the cathode may be electrically connected to the anode of the second-2 light emitting diode ED2c.

An additional modified embodiment that is different from the above-described modified embodiment will now be described, and the modified embodiment to be described below may be applied to the light emitting display device shown in FIGS. 1, 11, and 12.

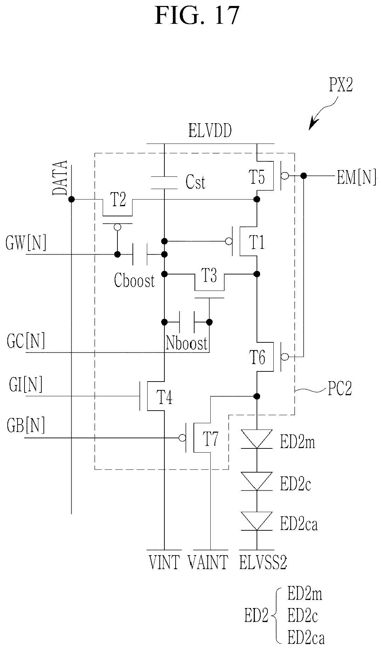

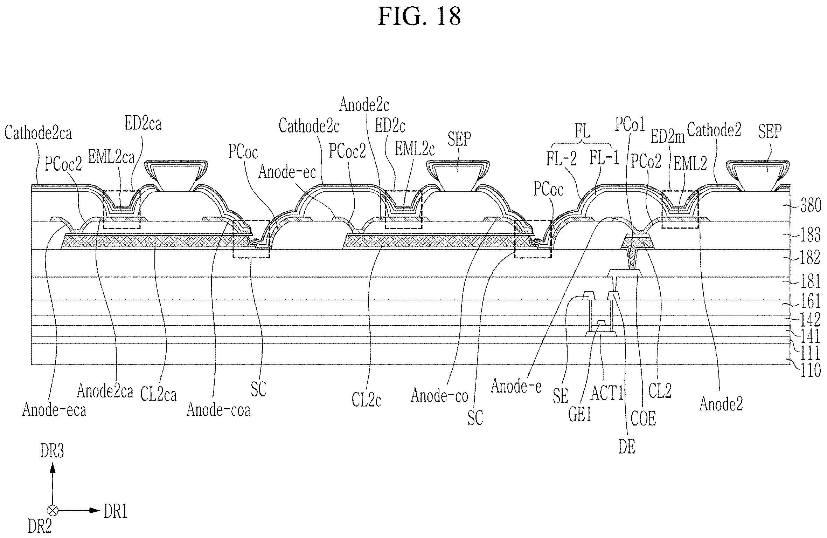

An embodiment in which three second light emitting diodes may be disposed in the second display area DA2 or the component region DA2-UPC will now be described with reference to FIGS. 17 and 18.

FIGS. 17 and 18 illustrate a schematic diagram of an equivalent circuit of a pixel and a schematic cross-sectional view of a light emitting display device according to another embodiment, respectively.

As shown in FIG. 17, the second light emitting diode ED2 may include one second-1 light emitting diode ED2m and two additional light emitting diodes ED2c and ED2ca.

The anode of the second-1 light emitting diode ED2m may receive an output current from the driving transistor T1 of the second pixel driver PC2, and the cathode of the second-3 light emitting diode ED2ca may receive the second-2 voltage ELVSS2. In the embodiment of FIG. 17, the second light emitting diode ED2 may have a serial connection structure in which the cathode of the second-1 light emitting diode ED2m is electrically connected to the anode of the second-2 light emitting diode ED2c, and the cathode of the second-2 light emitting diode ED2c is electrically connected to the anode of the second-3 light emitting diode ED2ca. As described, the three second light emitting diodes ED2m, ED2c, and ED2ca may be electrically connected in series and may emit light according to luminance corresponding to an output current.

A structure for electrically connecting the three second light emitting diodes ED2m, ED2c, and ED2ca will now be described according to a schematic cross-sectional diagram of FIG. 18.

A structure of the second planarization film 182 relating to the connection of the second light emitting diodes ED2m, ED2c, and ED2ca will now be described with reference to FIG. 18.

A third data conductive layer including a second anode connecting line CL2 and two second auxiliary anode connecting lines CL2c and CL2ca may be disposed on the second planarization film 182. The second anode connecting line CL2 may be electrically connected to the transistor of the pixel driver through the contact hole PCo1 disposed in the second planarization film 182 and may receive the output current. The third data conductive layer may have a triple-layered structure, and the triple-layered structure may include a lower portion layer and an upper portion layer including titanium (Ti), and an intermediate layer including aluminum (Al) between the lower portion layer and the upper portion layer.

A third planarization film 183 may be disposed on the third data conductive layer. The respective anodes Anode2, Anode2c, and Anode2ca and the auxiliary connecting members Anode-co and Anode-coa of the light emitting diodes ED2m, ED2c, and ED2ca may be formed (or disposed) on the third planarization film 183. The auxiliary connecting members Anode-co and Anode-coa may be made of substantially the same material as the anodes Anode2, Anode2c, and Anode2ca.

The anode Anode2 of the second-1 light emitting diode ED2m may have an extension Anode-e, and the extension Anode-e may be electrically connected to the second anode connecting line CL2 through the contact hole PCo2 and may receive an output current from the transistor of the pixel driver.

The anode Anode2c of the second-2 light emitting diode ED2c may have an extension Anode-ec, and the extension Anode-ec may be electrically connected to the second auxiliary anode connecting line CL2c through the contact hole PCoc2. The anode Anode2ca of the second-3 light emitting diode ED2ca may have an extension Anode-eca, and the extension Anode-eca may be electrically connected to the second auxiliary anode connecting line CL2ca through the contact hole PCoc2.

The auxiliary connecting members Anode-co and Anode-coa may be respectively disposed near (or adjacent to) the contact hole PCoc, and may help electrically connect the cathodes Cathode2 and Cathode2c and the second auxiliary anode connecting lines CL2c and CL2ca through the contact hole PCoc. In case that wet etching is performed to form the anode, particles of silver (Ag) may be reduced/precipitated near the third data conductive layer including exposed aluminum (Al), defects may be generated from the auxiliary connecting members Anode-co and Anode-coa for a subsequent process, and hence, generation of the particles of silver (Ag) may be prevented and the defects may be removed by forming the auxiliary connecting members Anode-co and Anode-coa that are anode materials. In an embodiment that does not have the above-noted problem, the auxiliary connecting members Anode-co and Anode-coa may be omitted in case that there is no problem in electrically connecting the cathode and the second auxiliary anode connecting lines CL2c and CL2ca.

A pixel defining layer 380 having openings for exposing the anodes Anode2, Anode2c, and Anode2ca and the auxiliary connecting members Anode-co and Anode-coa and covering at least part of the anodes Anode2, Anode2c, and Anode2ca and the auxiliary connecting members Anode-co and Anode-coa may be disposed on the anodes Anode2, Anode2c, and Anode2ca and the auxiliary connecting members Anode-co and Anode-coa.

A separator SEP may be disposed on the pixel defining layer 380. The separator SEP may have an inversely tapered side wall so that the layer disposed on an upper portion of the separator SEP may be electrically disconnected near the separator SEP. As a result, the cathode may be electrically separated with respect to the separator SEP.

A first functional layer FL-1 may be disposed on the pixel defining layer 380 and the separator SEP, and the first functional layer FL-1 may be electrically disconnected around the separator SEP.

The emission layers EML2, EMI,2c, and EMI,2ca may be respectively disposed on the anodes Anode2, Anode2c, and Anode2ca disposed on the first functional layer FL-1 and exposed in the opening of the pixel defining layer 380.

A second functional layer FL-2 may be disposed on the first functional layer FL-1 and the emission layers EML2, EML2c, and EML2ca, and the second functional layer FL-2 may be electrically disconnected near the separator SEP. The first functional layer FL-1 may contact the second functional layer FL-2 near a portion where the emission layers EML2, EMI,2c, and EML2ca are not disposed.

The cathodes Cathode2, Cathode2c, and Cathode2ca may be disposed on the second functional layer FL-2, and the cathodes Cathode2, Cathode2c, and Cathode2ca may be separated with respect to the separator SEP to configure the cathode Cathode2 of the second-1 light emitting diode ED2m, the cathode Cathode2c of the second-2 light emitting diode ED2c, and the cathode Cathode2ca of the second-3 light emitting diode ED2ca.

A combination of the functional layer FL and the emission layer may be referred to as an intermediate layer. The functional layer FL may include at least one of auxiliary layers including an electron injection layer, an electron transport layer, a hole transport layer, and a hole injection layer, the first functional layer FL-1 disposed on the lower portions of the emission layers EML2, EMI,2c, and EMI,2ca may include a hole injection layer and/or a hole transport layer, and the second functional layer FL-2 disposed on the upper portions of the emission layers EML2, EMI,2c, and EMI,2ca may include an electron transport layer and/or an electron injection layer.

The second-1 light emitting diode ED2m may include an anode Anode2, an emission layer EML2, and a cathode Cathode2, and may further include a first functional layer FL-1 disposed between the anode Anode2 and the emission layer EMI,2 and a second functional layer FL-2 disposed between the emission layer EML2 and the cathode Cathode2.

The second-2 light emitting diode ED2c may include an anode Anode2c, an emission layer EMI,2c, and a cathode Cathode2c, and may further include a first functional layer FL-1 disposed between the anode Anode2c and the emission layer EMI,2c and a second functional layer FL-2 disposed between the emission layer EMI,2c and the cathode Cathode2c. The second-3 light emitting diode ED2ca may include an anode Anode2ca, an emission layer EML2ca, and a cathode Cathode2ca, and may further include a first functional layer FL-1 disposed between the anode Anode2ca and the emission layer EML2ca and a second functional layer FL-2 disposed between the emission layer EML2ca and the cathode Cathode2ca.

At least portions of the cathode Cathode2 of the second-1 light emitting diode ED2m and the functional layer FL disposed below the same may overlap the auxiliary connecting member Anode-co, and may be electrically connected to the second auxiliary anode connecting line CL2c through the contact hole PCoc. The second auxiliary anode connecting line CL2c and the cathode Cathode2 of the second-1 light emitting diode ED2m may be electrically connected by a side-contact (SC) method. For example, the intermediate layer including aluminum (Al) of the triple-layered structure of the second auxiliary anode connecting line CL2c may be etched more than the lower portion layer and the upper portion layer including titanium (Ti), and the cathode Cathode2 of the second-1 light emitting diode ED2m and the intermediate layer of the second auxiliary anode connecting line CL2c may contact each other with the auxiliary connecting member Anode-co therebetween and may be electrically connected to each other. The auxiliary connecting member Anode-co may be electrically connected to the lower portion layer of the second auxiliary anode connecting line CL2c. The side-contact (SC) method may be one of electrically connecting methods according to an embodiment, and in some embodiments, various types of electrical connection methods are allowable.

The second auxiliary anode connecting line CL2c may be electrically connected to the anode Anode2c of the second-2 light emitting diode ED2c so that the cathode Cathode2 of the second-1 light emitting diode ED2m is electrically connected to the anode Anode2c of the second-2 light emitting diode ED2c and the light emitting diodes ED2m and ED2c are electrically connected in series.

At least part of the cathode Cathode2c of the second-2 light emitting diode ED2c and the functional layer FL disposed below the same may overlap the auxiliary connecting member Anode-coa, and may be electrically connected to the second auxiliary anode connecting line CL2ca through the contact hole PCoc. The second auxiliary anode connecting line CL2ca and the cathode Cathode2c of the second-2 light emitting diode ED2c may be electrically connected by the side-contact (SC) method. For example, the intermediate layer including aluminum (Al) of the triple-layered structure of the second auxiliary anode connecting line CL2ca may be etched more than the lower portion layer and the upper portion layer including titanium (Ti), and the cathode Cathode2c of the second-2 light emitting diode ED2c and the intermediate layer of the second auxiliary anode connecting line CL2ca may contact each other with the auxiliary connecting member Anode-coa therebetween and may be electrically connected to each other. The auxiliary connecting member Anode-coa may be electrically connected to the lower portion layer of the second auxiliary anode connecting line CL2ca. The side-contact (SC) method may be one of electrically connecting methods according to an embodiment, and in some embodiments, various types of electrical connection methods are allowable.

The second auxiliary anode connecting line CL2ca may be electrically connected to the anode Anode2ca of the second-3 light emitting diode ED2ca so that the cathode Cathode2c of the second-2 light emitting diode ED2c is electrically connected to the anode Anode2ca of the second-3 light emitting diode ED2ca.

Therefore, the light emitting diodes ED2m, ED2c, and ED2ca may be electrically connected in series.

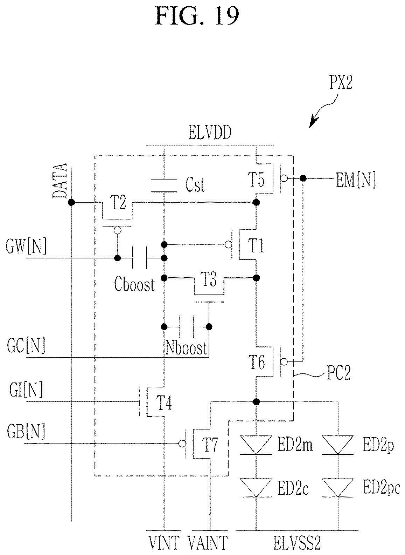

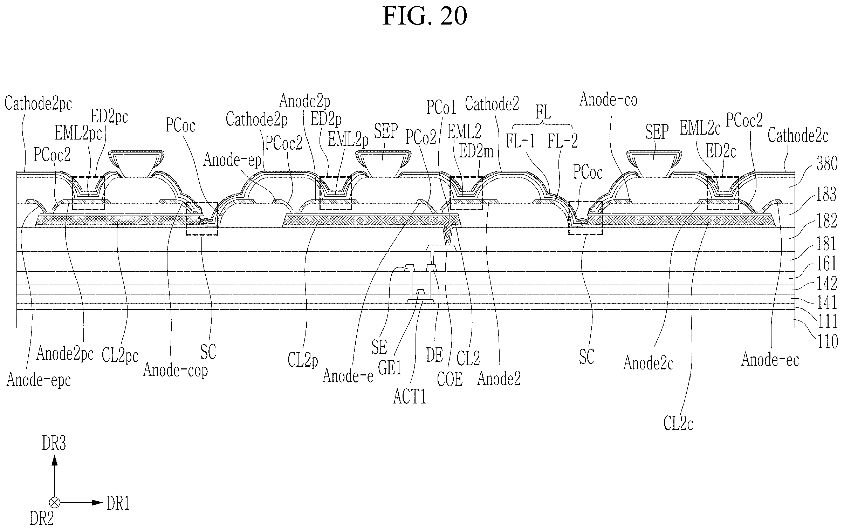

Differing from this, the second light emitting diode ED2 may include various numbers of the light emitting diodes, and in some embodiments, some of the light emitting diodes may be electrically connected in parallel. A modified embodiment in which some light emitting diode may be electrically connected in parallel will now be described with reference to FIGS. 19 and 20.

FIGS. 19 and 20 illustrate a schematic diagram of an equivalent circuit of a pixel and a schematic cross-sectional view of a light emitting display device according to another embodiment, respectively.

As shown in FIG. 19, the second light emitting diode ED2 may include one second-1 light emitting diode ED2m and three additional light emitting diodes ED2c, ED2p, and ED2pc, and the second-1 light emitting diode ED2m and the second-2 light emitting diode ED2c may be electrically connected in series to each other, and the second-4 light emitting diode ED2p and the second-5 light emitting diode ED2pc may be electrically connected in series to each other. The second-1 light emitting diode ED2m and the second-2 light emitting diode ED2c electrically connected in series may be electrically connected in parallel to the second-4 light emitting diode ED2p and the second-5 light emitting diode ED2pc electrically connected in series.

The anode of the second-1 light emitting diode ED2m may receive an output current from the driving transistor T1 of the second pixel driver PC2, and the cathodes of the second-2 light emitting diode ED2c and the second-5 light emitting diode ED2pc may receive the second-2 voltage ELVSS2. Regarding the second light emitting diode ED2 according to the embodiment of FIG. 19, the cathode of the second-1 light emitting diode ED2m may be electrically connected in series to the anode of the second-2 light emitting diode ED2c, and the cathode of the second-4 light emitting diode ED2p may be electrically connected in series to the anode of the second-5 light emitting diode ED2pc. The anode of the second-1 light emitting diode ED2m electrically connected in series to the anode of the second-4 light emitting diode ED2p may be electrically connected in parallel to the cathode of the second-2 light emitting diode ED2c electrically connected in series to the cathode of the second-5 light emitting diode ED2pc.

A structure for electrically connecting the four second light emitting diodes ED2m, ED2c, ED2p, and ED2pc will now be described with reference to a schematic cross-sectional diagram of FIG. 20.

Additionally, a structure above the second planarization film 182 relating to the connection of the second light emitting diodes ED2m, ED2c, ED2p and ED2pc will now be described in detail with reference to FIG. 20.

A third data conductive layer including one second anode connecting line CL2 and two second auxiliary anode connecting lines CL2c and CL2pc may be disposed on the second planarization film 182. Part of the second anode connecting line CL2 may function as the auxiliary anode connecting line CL2p. The second anode connecting line CL2 may be electrically connected to the transistor of the pixel driver through the contact hole PCo1 disposed in the second planarization film 182 and may receive an output current, and an auxiliary anode connecting line CL2p integral with the second anode connecting line CL2 may receive an output current. In the embodiment of FIG. 20, the third data conductive layer may have a triple-layered structure, and the triple-layered structure may include a lower portion layer and an upper portion layer including titanium (Ti), and an intermediate layer including aluminum (Al) between the lower portion layer and the upper portion layer.

A third planarization film 183 may be disposed on the third data conductive layer. The respective anodes Anode2, Anode2c, Anode2p, and Anode2pc and the auxiliary connecting members Anode-co and Anode-cop of the light emitting diodes ED2m, ED2c, ED2p, and ED2pc may be formed on the third planarization film 183. The auxiliary connecting members Anode-co and Anode-cop may be made of substantially the same material as the anodes Anode2, Anode2c, Anode2p, and Anode2pc.

The anode Anode2 of the second-1 light emitting diode ED2m may have an extension Anode-e, and the extension Anode-e may be electrically connected to the second anode connecting line CL2 through the contact hole PCo2 and may receive an output current from the transistor of the pixel driver.

The anode Anode2c of the second-2 light emitting diode ED2c may have an extension Anode-ec, and the extension Anode-ec may be electrically connected to the second auxiliary anode connecting line CL2c through the contact hole PCoc2.

The anode Anode2p of the second-4 light emitting diode ED2p may have an extension Anode-ep, and the extension Anode-ep may be electrically connected to the second auxiliary anode connecting line CL2p through the contact hole PCoc2.

The anode Anode2pc of the second-5 light emitting diode ED2pc may have an extension Anode-epc, and the extension Anode-epc may be electrically connected to the second auxiliary anode connecting line CL2pc through the contact hole PCoc2.

The auxiliary connecting members Anode-co and Anode-cop may be disposed near the contact hole PCoc, and may help electrically connect the cathodes Cathode2 and Cathode2p and the second auxiliary anode connecting lines CL2c and CL2pc through the contact hole PCoc. In case that wet etching is performed to form the anode, particles of silver (Ag) may be reduced/precipitated near the third data conductive layer including exposed aluminum (Al), defects may be generated from the auxiliary connecting members Anode-co and Anode-cop for a subsequent process, and hence, generation of the particles of silver (Ag) may be prevented and the defects may be removed by forming the auxiliary connecting members Anode-co and Anode-cop that are anode materials. In an embodiment that does not have the above-noted problem, the auxiliary connecting members Anode-co and Anode-cop may be omitted in case that there is no problem in electrically connecting the cathode and the second auxiliary anode connecting lines CL2c and CL2pc.

A pixel defining layer 380 having openings for exposing the anodes Anode2, Anode2c, Anode2p, and Anode2pc and the auxiliary connecting members Anode-co and Anode-cop and covering at least parts of the anodes Anode2, Anode2c, Anode2p, and Anode2pc and the auxiliary connecting members Anode-co and Anode-cop may be disposed on the anodes Anode2, Anode2c, Anode2p, and Anode2pc and the auxiliary connecting members Anode-co and Anode-cop.

A separator SEP may be disposed on the pixel defining layer 380. The separator SEP may have an inversely tapered side wall so that the layer disposed on an upper portion of the separator SEP may be electrically disconnected near the separator SEP. As a result, the cathode may be electrically separated with respect to the separator SEP.

A first functional layer FL-1 may be disposed on the pixel defining layer 380 and the separator SEP, and the first functional layer FL-1 may be electrically disconnected around the separator SEP.

The emission layers EML2, EMI,2c, EML2p, and EMI,2pc may be respectively disposed on the anodes Anode2, Anode2c, Anode2p, and Anode2pc disposed on the first functional layer FL-1 and exposed in the opening of the pixel defining layer 380.

A second functional layer FL-2 may be disposed on the first functional layer FL-1 and the emission layers EML2, EMI,2c, EMI,2p, and EMI,2pc, and the second functional layer FL-2 may be electrically disconnected near the separator SEP. The first functional layer FL-1 may contact the second functional layer FL-2 near a portion where the emission layers EML2, EMI,2c, EML2p, and EMI,2pc are not disposed.

The cathodes Cathode2, Cathode2c, Cathode2p, and Cathode2pc may be disposed on the second functional layer FL-2, the cathodes Cathode2, Cathode2c, Cathode2p, and Cathode2pc may be separated with respect to the separator SEP to configure the cathode Cathode2 of the second-1 light emitting diode ED2m, the cathode Cathode2c of the second-2 light emitting diode ED2c, the cathode Cathode2p of the second-4 light emitting diode ED2p, and the cathode Cathode2pc of the second-5 light emitting diode ED2pc.

A combination of the functional layer FL and the emission layer may be referred to as an intermediate layer. The functional layer FL may include at least one of auxiliary layers including an electron injection layer, an electron transport layer, a hole transport layer, and a hole injection layer, the first functional layer FL-1 disposed on the lower portions of the emission layers EML2, EMI,2c, EML2p, and EMI,2pc may include a hole injection layer and/or a hole transport layer, and the second functional layer FL-2 disposed on the upper portions of the emission layers EML2, EMI,2c, EML2p, and EMI,2pc may include an electron transport layer and/or an electron injection layer.

The second-1 light emitting diode ED2m may include an anode Anode2, an emission layer EML2, and a cathode Cathode2, and may further include a first functional layer FL-1 disposed between the anode Anode2 and the emission layer EMI,2 and a second functional layer FL-2 disposed between the emission layer EML2 and the cathode Cathode2.

The second-2 light emitting diode ED2c may include an anode Anode2c, an emission layer EML2c, and a cathode Cathode2c, and may further include a first functional layer FL-1 disposed between the anode Anode2c and the emission layer EMI,2c and a second functional layer FL-2 disposed between the emission layer EMI,2c and the cathode Cathode2c.

The second-4 light emitting diode ED2p may include an anode Anode2p, an emission layer EML2p, and a cathode Cathode2p, and may further include a first functional layer FL-1 disposed between the anode Anode2p and the emission layer EMI,2p and a second functional layer FL-2 disposed between the emission layer EMI,2p and the cathode Cathode2p.

The second-5 light emitting diode ED2pc may include an anode Anode2pc, an emission layer EML2pc, and a cathode Cathode2pc, and may further include a first functional layer FL-1 disposed between the anode Anode2pc and the emission layer EMI,2pc and a second functional layer FL-2 disposed between the emission layer EMI,2pc and the cathode Cathode2pc.

At least portions of the cathode Cathode2 of the second-1 light emitting diode ED2m and the functional layer FL disposed below the same may overlap the auxiliary connecting member Anode-co, and may be electrically connected to the second auxiliary anode connecting line CL2c through the contact hole PCoc. The second auxiliary anode connecting line CL2c and the cathode Cathode2 of the second-1 light emitting diode ED2m may be electrically connected by a side-contact (SC) method. For example, the intermediate layer including aluminum (Al) of the triple-layered structure of the second auxiliary anode connecting line CL2c may be etched more than the lower portion layer and the upper portion layer including titanium (Ti), and the cathode Cathode2 of the second-1 light emitting diode ED2m and the intermediate layer of the second auxiliary anode connecting line CL2c may contact each other with the auxiliary connecting member Anode-co therebetween and may be electrically connected to each other. The auxiliary connecting member Anode-co may be electrically connected to the lower portion layer of the second auxiliary anode connecting line CL2c. The side-contact (SC) method may be one of electrically connecting methods according to an embodiment, and in some embodiments, various types of electrical connection methods are allowable.

The second auxiliary anode connecting line CL2c may be electrically connected to the anode Anode2c of the second-2 light emitting diode ED2c so that the cathode Cathode2 of the second-1 light emitting diode ED2m is electrically connected to the anode Anode2c of the second-2 light emitting diode ED2c and the light emitting diodes ED2m and ED2c are electrically connected in series.

At least portions of the cathode Cathode2p of the second-4 light emitting diode ED2p and the functional layer FL disposed below the same may overlap the auxiliary connecting member Anode-cop, and may be electrically connected to the second auxiliary anode connecting line CL2pc through the contact hole PCoc. The second auxiliary anode connecting line CL2pc and the cathode Cathode2p of the second-4 light emitting diode ED2p may be electrically connected by the side-contact (SC) method. For example, the intermediate layer including aluminum (Al) of the triple-layered structure of the second auxiliary anode connecting line CL2pc may be etched more than the lower portion layer and the upper portion layer including titanium (Ti), and the cathode Cathode2p of the second-4 light emitting diode ED2p and the intermediate layer of the second auxiliary anode connecting line CL2pc may contact each other with the auxiliary connecting member Anode-cop therebetween and may be electrically connected to each other. The auxiliary connecting member Anode-cop may be electrically connected to the lower portion layer of the second auxiliary anode connecting line CL2pc. The side-contact (SC) method may be one of electrically connecting methods according to an embodiment, and in some embodiments, various types of electrical connection methods are allowable.

As the second auxiliary anode connecting line CL2pc is electrically connected to the anode Anode2pc of the second-5 light emitting diode ED2pc, the cathode Cathode2p of the second-4 light emitting diode ED2p may be electrically connected to the anode Anode2pc of the second-5 light emitting diode ED2pc. Therefore, the second-4 light emitting diode ED2p may be electrically connected in series to the second-5 light emitting diode ED2pc.

The anode Anode2 of the second-1 light emitting diode ED2m may be electrically connected to the anode Anode2p of the second-4 light emitting diode ED2p, and the cathode Cathode2c of the second-2 light emitting diode ED2c may be electrically connected to the cathode Cathode2pc of the second-5 light emitting diode ED2pc so that they are electrically connected in parallel between the two light emitting diodes electrically connected in series.

The number and connection relationships of the elements included in the second light emitting diode ED2 may not be limited to the above-described embodiment, and they may have various numbers and various connection relationships.

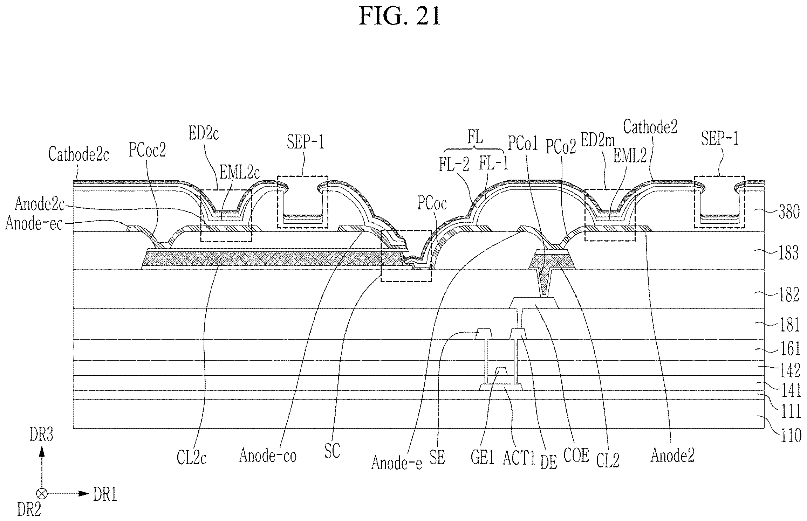

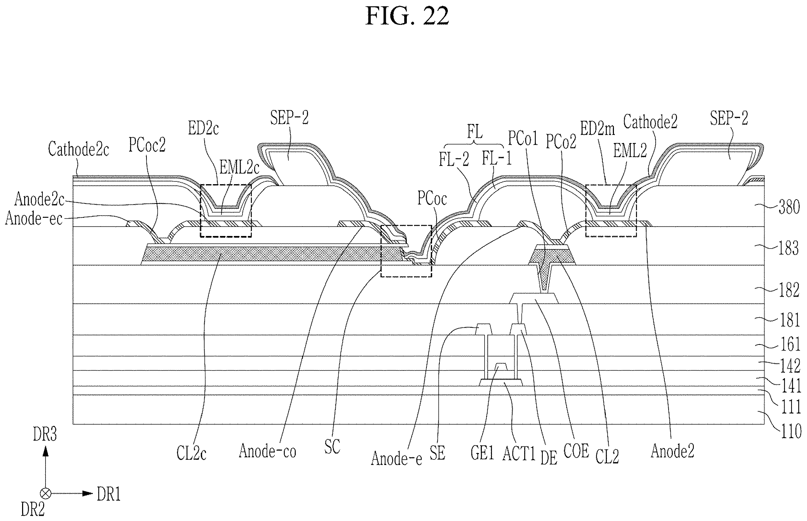

A light emitting display device including a separator SEP-1 with another structure will now be described with reference to FIGS. 21 and 22.

FIGS. 21 and 22 illustrate schematic cross-sectional views of a light emitting display device according to another embodiment.

FIG. 21 illustrates a concave separator SEP-1, differing from FIG. 6. The separator SEP-1 may allow the layer disposed on the upper portion to be electrically disconnected near the separator SEP-1.

The separator SEP-1 may be formed to have a groove shape that is concave in the pixel defining layer 380. The groove configuring the separator SEP-1 may be over-etched or may be formed to be deeper than a depth (e.g., a predetermined or selectable depth) so that the layer disposed at the upper portion of the separator SEP-1 may be electrically disconnected. Therefore, the functional layer FL and the cathode disposed on the upper portion of the separator SEP-1 may be electrically disconnected at the separator SEP-1.

The structure of FIG. 21 and the structure of FIG. 5 may have a same circuit so that the structure of FIG. 21 and the structure of FIG. 6 may perform substantially a same operation.

FIG. 22 illustrates a separator SEP-2 including one side with an inversely tapered side wall and another side with a tapered side wall, differing from FIG. 6. The separator SEP-2 may have a structure in which the layer on the upper portion is electrically disconnected on the inversely tapered side wall, and the layer on the upper portion is electrically connected on the tapered side wall. In the embodiment of FIG. 22, the separator SEP-2 may electrically disconnect the layer on the upper portion on one side, and the layer disposed on the upper portion of the separator SEP-2 may be electrically connected to one side of the separator SEP-2. As a result, the cathode layer disposed on the upper portion of the separator SEP-2 may be electrically connected to the cathode of the light emitting diode disposed on one side of the separator SEP-2 and may not float. In case that a constant voltage is applied compared to the structure in which the conductive layer disposed on the upper portion of the separator floats, a potential of the floating conductive layer may be changed, and the drawback of giving an influence to the peripheral pixels may be accordingly removed.

As shown in FIG. 22, the separator SEP-2 with different structures of respective side walls may be formed by using a halftone mask, adjusting an amount of exposure, and adjusting a tapered angle of the side walls.

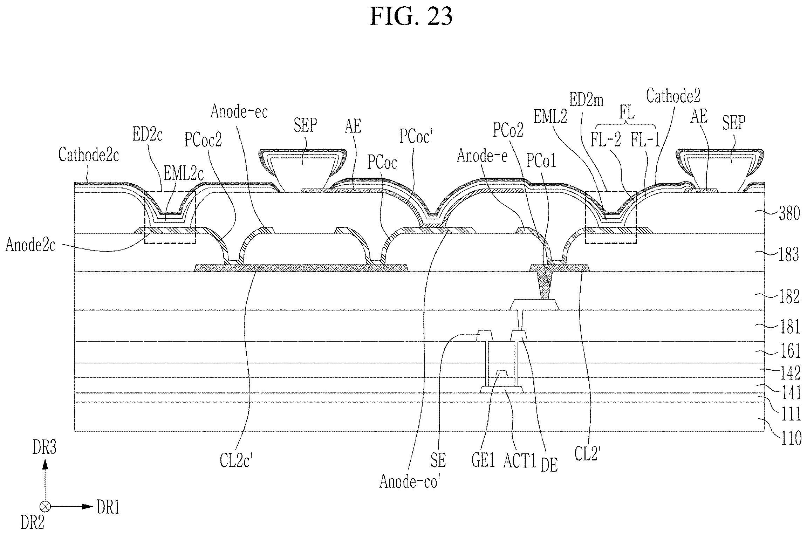

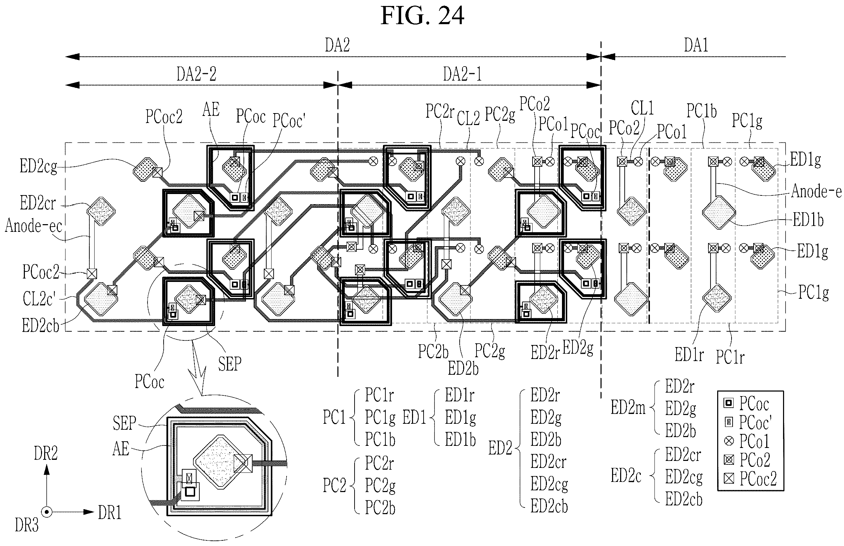

In some embodiments, an additional conductive portion AE may be formed in a like way of the separator, which will now be described with reference to FIGS. 23 and 24.

FIGS. 23 and 24 illustrate a schematic cross-sectional view and a schematic top plan view of a light emitting display device according to another embodiment.

Referring to FIG. 23, the additional conductive portion AE overlapping part of the separator SEP may be formed below the separator SEP. The additional conductive portion AE may be disposed on one side of the separator SEP and may not extend to another side thereof.

The difference in the embodiment of FIG. 23 is that the additional conductive portion AE is formed and the side-contact (SC) is not performed. For example, the additional conductive portion AE may be electrically connected to the upper portion side of the auxiliary connecting member Anode-co through a contact hole PCoc'. The additional conductive portion AE may contact the cathode Cathode2 near the separator SEP. For example, it may not be easy for the additional conductive portion AE to be electrically connected to the auxiliary connecting member Anode-co because of the functional layer FL disposed below the cathode Cathode2, the additional conductive portion AE may be formed to partly overlap the separator SEP and protrude from the separator SEP so that the functional layer FL may not be formed therebetween near the separator SEP and the cathode Cathode2 may contact the additional conductive portion AE. The above-noted structure may represent a connection method using a point that the cathodeCathode2 is formed to be longer than the functional layer FL in case that the cathode Cathode2 and the functional layer FL are separated from the separator SEP. However, various types of electrical connections are allowable in addition to the above-noted method. Therefore, the cathode Cathode2 may be electrically connected to the auxiliary connecting member Anode-co through the additional conductive portion AE, and the anode Anode2c and the cathode Cathode2 of the second-2 light emitting diode ED2c may be electrically connected.

A second anode connecting line CL2' and a second auxiliary anode connecting line CL2c' included in the third data conductive layer may be formed to be a single layer rather than a triple layer.

FIG. 24 illustrates a planar structure of the additional conductive portion AE formed below the separator SEP according to an embodiment.

FIG. 24 illustrates the additional conductive portion AE extending along an internal side of the separator SEP and marked with a thick solid line, differing from FIG. 6. The additional conductive portion AE may be electrically connected to the contact hole PCoc'. The adjacent contact hole PCoc' and the contact hole PCoc2 may be electrically connected by an auxiliary connecting member Anode-co' shown in FIG. 23. Referring to FIGS. 23 and 24, the cathode Cathode2 separated by the separator SEP may be electrically connected to the additional conductive portion AE formed along the separator SEP, may be electrically connected to the auxiliary connecting member Anode-co' through the contact hole PCoc', may be electrically connected to the second auxiliary anode connecting line CL2c through the contact hole PCoc2, and may be electrically connected to the anode Anode2c through the contact hole PCoc2. As a result, the cathode Cathode2 of the second-1 light emitting diode ED2m may be electrically connected to the anode Anode2c of the second-2 light emitting diode ED2c, and the second-1 light emitting diode ED2m and the second-2 light emitting diode ED2c may be electrically connected in series.

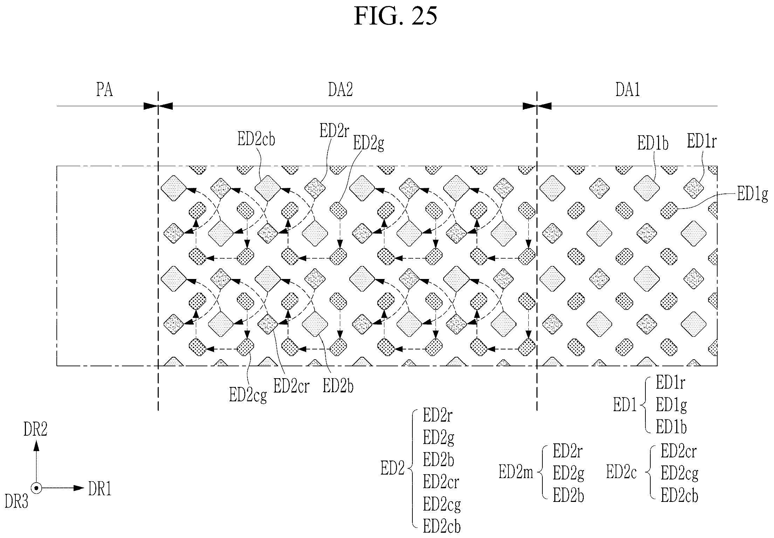

The embodiment in which the number of the additional light emitting diodes for all colors are the same has been described. However, in some embodiments, the number of the additional light emitting diodes may be different according to colors and/or positions, which will now be described with reference to FIGS. 25 to 28.

FIGS. 25 to 28 illustrate plan views of a light emitting display device according to another embodiment.

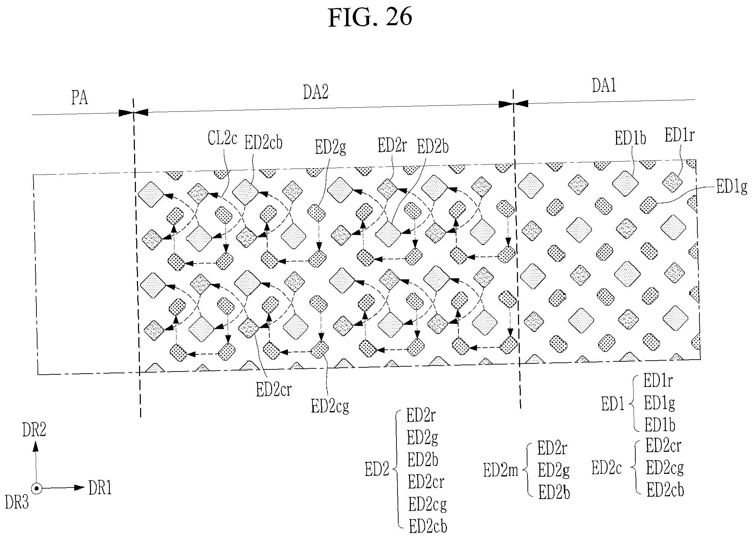

An embodiment in which the numbers of the additional light emitting diodes are the same according to the colors and another embodiment in which the numbers thereof are different will now be compared and described based on embodiments of FIGS. 25 and 26. FIGS. 25 and 26 illustrate an enlarged part of a light emitting display device according to the embodiment of FIG. 1, illustrating the light emitting diodes ED1 and ED2. Arrows shown in FIGS. 25 and 26 illustrate the light emitting diodes electrically connected in series, not illustrating the separator for separating the cathode to electrically connect the light emitting diodes in series.

Referring to FIG. 25, three second-2 light emitting diodes ED2c formed in the second display area DA2 may be respectively included for red, green, and blue. As the second-1 light emitting diode ED2m is included, four light emitting diodes may be electrically connected in series.

On the contrary, referring to FIG. 26, the green light emitting diode may include a second-1 light emitting diode ED2g and three second-2 light emitting diodes ED2cg, the red light emitting diode may include a second-1 light emitting diode ED2r and a second-2 light emitting diode ED2cr, and the blue light emitting diode may include a second-1 light emitting diode ED2b and a second-2 light emitting diode ED2cb.

The embodiment shown in FIGS. 25 and 26 may have the same disposition of the second light emitting diode ED2, but may have different numbers of the light emitting diodes electrically connected in series so that the numbers of second pixel drivers (not shown) for transmitting the output current to the second light emitting diode ED2 may also be different from each other.

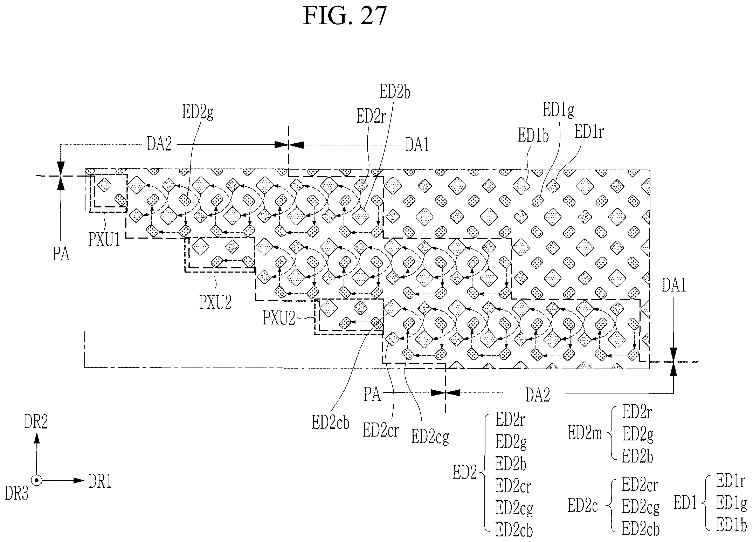

FIG. 27 illustrates an embodiment displaying different numbers of additional light emitting diodes for respective positions in the second display area DA2 of the light emitting display device according to an embodiment of FIG. 11.

FIG. 27 illustrates an enlarged second display area DA2 disposed near a corner DA-C in the light emitting display device of FIG. 11. FIG. 27 also illustrates light emitting diodes ED 1 and ED2, the arrows indicates that the light emitting diodes are electrically connected in series to each other, and FIG. 27 does not illustrate the separator for separating the cathode to electrically connect the light emitting diodes in series.

In the embodiment of FIG. 27, three second-2 light emitting diodes ED2c may be respectively included for red, green, and blue in most positions in the second display area DA2 of the light emitting display device, and in case that the second-1 light emitting diode ED2m is included, the four light emitting diodes may be electrically connected in series.

However, some of the light emitting diodes disposed on the corner of the light emitting display device may not be included in the four light emitting diodes electrically connected in series but may remain. In the embodiment of FIG. 27, at least one of the second-1 light emitting diodes ED2m may include unit second light emitting diodes PXU1 and PXU2 that are differently formed from the second-1 light emitting diode ED2m with the different number of the electrically connected second-2 light emitting diodes ED2c. The first unit second light emitting diode PXU1 and the second unit second light emitting diode PXU2 may be additionally configured by using the remaining second light emitting diodes in the second display area DA2.

The first unit second light emitting diode PXU1 may include a red second-1 light emitting diode ED2r and a green second-1 light emitting diode ED2g and may not include an additional light emitting diode.

The second unit second light emitting diode PXU2 may include a red second-1 light emitting diode ED2r, a blue second-1 light emitting diode ED2b, and two green second light emitting diodes ED2g and ED2cg. One green second light emitting diode ED2cg of the two green second light emitting diodes ED2g and ED2cg may be an additional light emitting diode.

In the embodiment of FIG. 27, an additional light emitting diode may not be electrically connected to the second display area DA2, and the second-1 light emitting diode may be included. Another light emitting diode and another additional light emitting diode may be included.

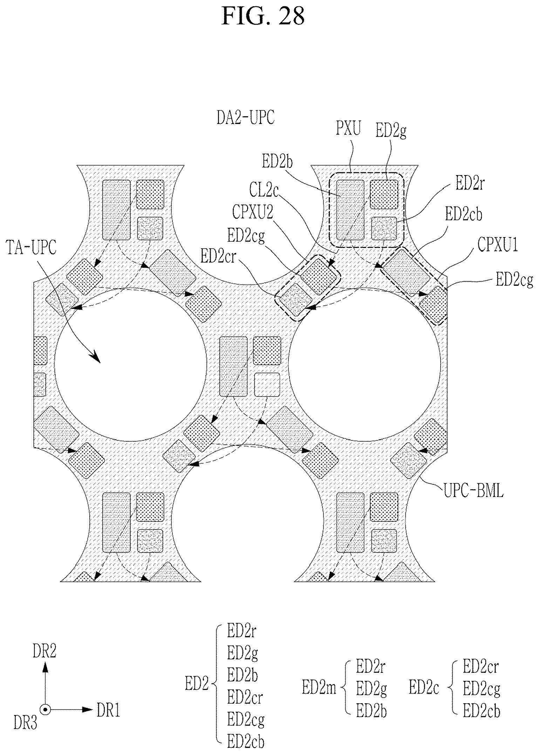

FIG. 28 illustrates an arrangement of light emitting diodes of the component region DA2-UPC of the light emitting display device according to an embodiment of FIG. 12. The arrows indicate the light emitting diodes electrically connected in series to each other, and FIG. 28 does not illustrate the separator for separating the cathode to electrically connect the light emitting diodes in series.

The light transmitting area TA-UPC may be partitioned in the component region DA2-UPC, a lower shielding layer UPC-BMI, made of a metal may be disposed therein, and the second light emitting diode ED2 and a pixel driver (not shown) may be disposed on the lower shielding layer UPC-BML.

The second-1 light emitting diode ED2m and the second-2 light emitting diode ED2c may be configured as a second-1 unit light emitting diode PXU (also referred to as a main unit light emitting diode) and additional unit light emitting diodes CPXU1 and CPXU2 (also referred to as additional unit light emitting diodes), the second-1 unit light emitting diode PXU may include red, green, and blue second-1 light emitting diodes ED2m, and the additional unit light emitting diodes CPXU1 and CPXU2 may include second-2 light emitting diodes ED2c for at least two colors of red, green, and blue. The second-1 unit light emitting diode PXU and the additional unit light emitting diodes CPXU1 and CPXU2 may be disposed on the lower shielding layer UPC-BML. The component region DA2-UPC may include the second-1 unit light emitting diodes PXU configured as the red, green, and blue second-1 light emitting diodes ED2m, and may include the additional unit light emitting diodes CPXU1 and CPXU2 including the second-2 light emitting diodes ED2c for at least two colors of red, green, and blue. The second-1 additional unit light emitting diode CPXU1 (also referred to as a first additional unit light emitting diode) may include the green second-2 light emitting diode ED2cg and the blue second-2 light emitting diode ED2cb, and the second-2 additional unit light emitting diode CPXU2 (also referred to as an additional unit light emitting diode) may include the green second-2 light emitting diode ED2cg and the red second-2 light emitting diode ED2cr. The pixel driver may be disposed on the lower portion of the second-1 unit light emitting diode PXU.

According to the structure of FIG. 28, the camera disposed on the rear side of the component region DA2-UPC may not only photograph the front side of the light emitting display device through the light transmitting area TA-UPC, but also may display images by the second-1 unit light emitting diode PXU and the additional unit light emitting diodes CPXU1 and CPXU2 disposed in the component region DA2-UPC, thereby having the merit of widening the display area . Further, the additional unit light emitting diodes CPXU1 and CPXU2 may be included, and the resolution of the images displayed by the component region DA2-UPC may be increased.

The above description is an example of technical features of the disclosure, and those skilled in the art to which the disclosure pertains will be able to make various modifications and variations. Thus, the embodiments of the disclosure described above may be implemented separately or in combination with each other.

Therefore, the embodiments disclosed in the disclosure are not intended to limit the technical scope of the invention, which is defined by the attached claims.

## Claims

1. A light emitting display device comprising:
a first display area; and
a second display area disposed on an external side of the first display area, wherein
the second display area includes:
a pixel driver;
a main light emitting diode electrically connected to the pixel driver; and
an additional light emitting diode electrically connected to the main light emitting diode,
the additional light emitting diode overlaps a peripheral driver that generates signals provided to the pixel driver,
the main light emitting diode and the additional light emitting diode each include a first electrode, an emission layer, and a second electrode, and
the second electrode of the main light emitting diode is electrically connected to the first electrode of the additional light emitting diode.

2. The light emitting display device of claim 1, wherein the second electrode of the main light emitting diode is electrically disconnected from the second electrode of the additional light emitting diode by a separator wherein, optionally, the light emitting display device further comprises:
a pixel defining layer including an opening overlapping the first electrode of the main light emitting diode and the first electrode of the additional light emitting diode, wherein
the separator is disposed on the pixel defining layer, and
the separator has a protruding structure including an inversely tapered side wall, and wherein, optionally, the light emitting display device further comprises:
an additional conductive portion overlapping part of the separator, disposed below the separator, and extending along the separator,
wherein the additional conductive portion is electrically connected to an end of the second electrode separated by the separator.

3. The light emitting display device of claim 2, further comprising:
a pixel defining layer including an opening overlapping the first electrode of the main light emitting diode and the first electrode of the additional light emitting diode,
wherein the separator is provided to be a concave groove in the pixel defining layer.

4. The light emitting display device of claim 2 or claim 3, further comprising:
an auxiliary anode connecting line that electrically connects the second electrode of the main light emitting diode and the first electrode of the additional light emitting diode, wherein
the auxiliary anode connecting line has a triple-layered structure, and
the second electrode of the main light emitting diode and the auxiliary anode connecting line have portions side-contacting each other, wherein optionally, the light emitting display device, further comprising:
an auxiliary connecting member disposed between the portions of the second electrode of the main light emitting diode and the auxiliary anode connecting line,
wherein the auxiliary connecting member and the first electrode of the main light emitting diode include a same material.

5. The light emitting display device of any of claims 2 to 4, further comprising:
an additional separator disposed between the first display area and the second display area, wherein
the first display area includes:
a pixel driver; and
a first light emitting diode electrically connected to the pixel driver,
the first light emitting diode includes a first electrode, an emission layer, and a second electrode, and
a voltage applied to the second electrode of the first light emitting diode and a voltage applied to the second electrode of the additional light emitting diode have different voltage values.

6. The light emitting display device of any of claims 2 to 5, wherein
the second display area further includes a second-4 light emitting diode and a second-5 light emitting diode electrically connected in series, and
the second-4 light emitting diode and the second-5 light emitting diode are electrically connected in parallel to the main light emitting diode and the additional light emitting diode.

7. The light emitting display device of any of claims 2 to 6, wherein
the main light emitting diode and the additional light emitting diode each emit one of red, green, and blue,
the main light emitting diode includes main light emitting diodes,
the additional light emitting diode includes additional light emitting diodes, and
a number of the additional light emitting diodes electrically connected to the main light emitting diode emitting one of red, green, and blue is different from a number of the additional light emitting diodes electrically connected to the main light emitting diode emitting another of red, green, and blue.

8. The light emitting display device of any of claims 2 to 7, wherein
the second display area is disposed on a portion that corresponds to a corner of the first display area,
the main light emitting diode includes main light emitting diodes,
the additional light emitting diode includes additional light emitting diodes, and
at least one of the main light emitting diodes includes a unit second light emitting diode in which a number of the additional light emitting diodes electrically connected to one of the main light emitting diodes is different from a number of the additional light emitting diodes electrically connected to another one of the main light emitting diodes.

9. A light emitting display device comprising:
a first display area; and
a second display area surrounded by the first display area and including a light transmitting area, wherein
the second display area includes a pixel driver, and a main light emitting diode and an additional light emitting diode electrically connected to the pixel driver,
the main light emitting diode and the additional light emitting diode each include a first electrode, an emission layer, and a second electrode, and
the second electrode of the main light emitting diode is electrically connected to the first electrode of the additional light emitting diode.

10. The light emitting display device of claim 9, wherein the second electrode of the main light emitting diode is electrically disconnected from the second electrode of the additional light emitting diode by a separator, wherein optionally, the light emitting display device further comprises:
a pixel defining layer including an opening overlapping the first electrode of the main light emitting diode and the first electrode of the additional light emitting diode, wherein
the separator is disposed on the pixel defining layer, and
the separator has a protruding structure including an inversely tapered side wall.

11. The light emitting display device of claim 10, further comprising:
an additional conductive portion overlapping part of the separator, disposed below the separator, and extending along the separator,
wherein the additional conductive portion is electrically connected to an end of a cathode separated by the separator.

12. The light emitting display device of claim 10 or claim 11, further comprising:
a pixel defining layer including an opening overlapping the first electrode of the main light emitting diode and the first electrode of the additional light emitting diode,
wherein the separator has a concave groove in the pixel defining layer, wherein optionally, the light emitting display device further comprises:
an auxiliary anode connecting line that electrically connects a cathode of the main light emitting diode and an anode of the additional light emitting diode,
wherein the auxiliary anode connecting line includes a transparent conductive material.

13. The light emitting display device of any of claims 10 to 12, further comprising:
an additional separator disposed between the first display area and the second display area, wherein
the first display area includes:
a pixel driver; and
a first light emitting diode electrically connected to the pixel driver,
the first light emitting diode includes a first electrode, an emission layer, and a second electrode, and
a voltage applied to the second electrode of the first light emitting diode and a voltage applied to the second electrode of the additional light emitting diode have different voltage values.

14. The light emitting display device of any of claims 10 to 13, wherein
the second display area further includes a lower shielding layer partitioning the light transmitting area, the lower shielding layer including a metal,
the main light emitting diode and the additional light emitting diode include a main unit light emitting diode and an additional unit light emitting diode, respectively,
the main unit light emitting diode includes main light emitting diodes emitting red, green, and blue,
the additional unit light emitting diode includes additional light emitting diodes emitting at least two of red, green, and blue, and
the main unit light emitting diode and the additional unit light emitting diode are disposed on the lower shielding layer.

15. The light emitting display device of claim 14, wherein the additional unit light emitting diode includes:
a first additional unit light emitting diode including the additional light emitting diode emitting green and the additional light emitting diode emitting blue; and
a second additional unit light emitting diode including the additional light emitting diode emitting green and the additional light emitting diode emitting red.
